# EUROPEAN PATENT SPECIFICATION

(11) **EP 4 567 901 B1**
(45) Date of publication and mention of the grant of the patent: **25.11.2026**
(21) Application number: 23858899.0
(22) Date of filing: 29.06.2023
(51) Int. Cl.: H10D 30/01, H10D 30/67

(54) **CHIP AND MANUFACTURING METHOD THEREFOR, AND ELECTRONIC DEVICE**
CHIP UND HERSTELLUNGSVERFAHREN DAFÜR SOWIE ELEKTRONISCHE VORRICHTUNG
PUCE ET SON PROCÉDÉ DE FABRICATION, ET DISPOSITIF ÉLECTRONIQUE

(30) Priority: 31.08.2022 CN 202211055661
(43) Date of publication of application: 11.06.2025
(73) Proprietor: Huawei Technologies Co., Ltd., Shenzhen, Guangdong 518129 (CN)
(72) Inventor: HUANG, Kailiang, Shenzhen, Guangdong 518129 (CN); JING, Weiliang, Shenzhen, Guangdong 518129 (CN); ZHANG, Wenqiang, Shenzhen, Guangdong 518129 (CN); WANG, Zhaogui, Shenzhen, Guangdong 518129 (CN); WANG, Zhengbo, Shenzhen, Guangdong 518129 (CN); LIAO, Heng, Shenzhen, Guangdong 518129 (CN); KAR, Gouri Sankar, 3001 Leuven (BE); BANERJEE, Kaustuv, 3001 Leuven (BE)
(74) Representative: Thun, Clemens
(86) International application number: PCT/CN2023/104226
(87) International publication number: WO 2024/045861

(56) References cited:
- CN-A- 111 384 156
- CN-A- 112 582 464
- CN-A- 113 745 346
- KR-B1- 101 684 798
- US-A1- 2020 006 575
- US-A1- 2020 006 575
- US-A1- 2022 190 169
- US-A1- 2022 199 836

## Description

### TECHNICAL FIELD

This application relates to the chip manufacturing field, and in particular, to a chip and a preparation method thereof, and an electronic device.

### BACKGROUND

A memory has a storage function. A reading speed of each storage unit in the memory is one of factors that affect performance of the memory. The storage unit includes a transistor, and performance of the transistor determines the reading speed of the storage unit.

Currently, as a transistor disposed in the memory, a thin film transistor (TFT) has a performance advantage of ultra-low electric leakage and a good gate control capability. This improves storage density and a reading speed of the memory to some extent.

However, as a size of a TFT device gradually shrinks, a gate control capability (a smaller gate voltage swing S indicates a poorer gate control capability) of the TFT device is limited, and consequently the TFT device cannot meet a requirement for further improving the storage density and the reading speed of the memory. US 2022/199836 A1 discloses a chip comprising a substrate and a transistor formed on the substrate, according to the prior art.

### SUMMARY

Embodiments of this application provide a chip and a preparation method thereof, and an electronic device. This resolves a problem that a gate control capability of the chip decreases as a size of a device shrinks.

The chip provided in embodiments of this application may be used in an electronic device having a TFT-type display or a TFT-type screen, or may be disposed on the electronic device as a memory.

To achieve the foregoing objective, the following technical solutions are used in embodiments of this application.

According to a first aspect, a chip is provided. The chip includes: a substrate and a transistor formed on the substrate, where the transistor includes: a first electrode, a second electrode, a channel layer, a gate, and a gate dielectric layer; the first electrode is stacked on the substrate, the second electrode is stacked on a side that is of the first electrode and that is away from the substrate, the second electrode has a first surface away from the first electrode, and the first surface is provided with a first channel hole extending into the first electrode; a part that is of a side wall of the first channel hole and that is located between the first electrode and the second electrode is concave in a direction parallel to the substrate to form a concave cavity, so that a side wall surface of the first channel hole is a concave wall surface; the channel layer covers the concave wall surface; and the gate covers the channel layer, and the gate and the channel layer are isolated through the gate dielectric layer.

According to the foregoing descriptions of the chip structure provided in this embodiment of this application, it can be learned that the side wall surface of the first channel hole of the chip is the concave wall surface, and the channel layer is formed on the concave wall surface. The concave wall surface includes a wall surface of the concave cavity formed by the part that is of the side wall of the first channel hole and that is concave in the direction parallel to the substrate. In comparison with a structure in which the side wall of the first channel hole is not concave, a forming position of the channel layer is increased on the wall surface of the formed concave cavity, so that an area of a cross section that is of the channel layer and that is parallel to the substrate is increased. In addition, the concave cavity is located between the first electrode and the second electrode. In this way, a part of a surface of the first electrode and a part of a surface of the second electrode form the wall surface of the concave cavity. Further, a contact area between the channel layer disposed on the wall surface of the concave cavity and the first electrode and a contact area between the channel layer and the second electrode are increased, thereby improving a gate control capability, and increasing an on-state current of the chip.

In addition, the gate and the channel layer are isolated through the gate dielectric layer, so that electrical isolation between the gate and the channel layer can be implemented, and electrical isolation between the first electrode and the gate and electrical isolation between the second electrode and the gate can be implemented.

In a feasible implementation of the first aspect, the first surface is covered with the channel layer, the channel layer on the first surface is covered with the gate, and the channel layer on the first surface and the gate are isolated through the gate dielectric layer.

The channel layer is continuously stacked on the first surface, so that the contact area between the channel layer and the second electrode is increased. In addition, the gate extends from the first channel hole into the first surface, and the gate dielectric layer isolates the gate and the channel layer that are located on the first surface, thereby implementing the electrical isolation between the channel layer and the gate.

In a feasible implementation of the first aspect, the gate, the gate dielectric layer, and the channel layer fill the first channel hole.

In this way, the gate fills the first channel hole. This is easy to process, and facilitates array arrangement and production of the transistor.

In a feasible implementation of the first aspect, the chip further includes: a dielectric layer, formed on the side that is of the first electrode and that is away from the substrate, where the concave cavity is formed in the dielectric layer, and the concave cavity passes through the dielectric layer in a direction perpendicular to the substrate.

In this way, the dielectric layer is formed between the first electrode and the second electrode, so that the concave wall surface of the first channel hole can be formed by performing transverse etching on the dielectric layer, and the dielectric layer can implement electrical isolation between the first electrode and the second electrode. In addition, the dielectric layer can avoid a carrier diffusion phenomenon at a contact position between the first electrode and the channel layer and a contact position between the second electrode and the channel layer, thereby avoiding electric leakage.

In a feasible implementation of the first aspect, the chip further includes a first doped layer, formed on a surface that is of the first electrode and that is away from the substrate.

The first doped layer is formed between the channel layer and a surface that is of the first electrode and that is close to the second electrode, so that ohmic contact between the first electrode and the channel layer can be improved, and an on-state current of the transistor can be further increased.

In a feasible implementation of the first aspect, a doping type of the first doped layer is different from that of the channel layer, one of the first doped layer and the channel layer is of P-type doping, and the other is of N-type doping.

In this way, one of the first doped layer and the channel layer is of P-type doping, and the other is of N-type doping, to implement PN junction contact, increase a probability of bonding carriers (electrons and electron holes), and further improve the on-state current of the transistor.

In a feasible implementation of the first aspect, the chip further includes a second doped layer, where the second doped layer is stacked on a side that is of the first doped layer and that is away from the first electrode.

The second doped layer is formed between the channel layer and a surface that is of the second electrode and that is close to the first electrode, so that ohmic contact between the second electrode and the channel layer can be improved, and an on-state current of the transistor can be further increased.

In a feasible implementation of the first aspect, a doping type of the second doped layer is different from that of the channel layer, one of the second doped layer and the channel layer is of P-type doping, and the other is of N-type doping.

In this way, one of the second doped layer and the channel layer is of P-type doping, and the other is of N-type doping, to implement PN junction contact, increase a probability of bonding carriers (electrons and electron holes), and further improve the on-state current of the transistor.

In addition, one of the first doped layer and the channel layer is of P-type doping, and the other is of N-type doping. The doping type of the second doped layer is the same as the doping type of the first doped layer.

In a feasible implementation of the first aspect, a part of a region of the first doped layer is a doped region, and a part of a region of the second doped layer is a doped region.

In a feasible implementation of the first aspect, where a boundary of an orthographic projection, on the substrate, of a part that is of the channel layer and that is located between the first electrode and the second electrode is located within a boundary of an overlapping part between an orthographic projection of the first electrode on the substrate and an orthographic projection of the second electrode on the substrate.

When the contact area between the channel layer and the first electrode and the contact area between the channel layer and the second electrode are increased, a volume of the transistor is not increased, and the volume and performance of the transistor are considered.

In a feasible implementation of the first aspect, a boundary of an orthographic projection, on the substrate, of a part that is of the channel layer and that is located between the first electrode and the second electrode is located outside a boundary of an overlapping part between an orthographic projection of the first electrode on the substrate and an orthographic projection of the second electrode on the substrate.

In this way, the contact area between the channel layer and the first electrode and the contact area between the channel layer and the second electrode are further increased, thereby further improving the gate control capability, and further increasing the on-state current of the chip.

In a feasible implementation of the first aspect, the gate has an upper surface and a lower surface that are located at two ends of the gate in the direction perpendicular to the substrate, the upper surface is a surface that is of the gate and that is away from the first electrode, the upper surface is provided with a gap that sequentially passes through the gate, the gate dielectric layer, the channel layer, and the first electrode, and the gap is filled with an insulating medium material.

In this way, a volume of each transistor is further reduced, and integration of the transistor is further improved.

In a feasible implementation of the first aspect, the chip is a memory, the memory includes a storage unit, and the storage unit includes a transistor.

In this embodiment of this application, a chip having a large on-state current is used as the memory, so that a reading delay of the memory can be effectively reduced.

According to a second aspect, a chip preparation method is provided. The preparation method includes: stacking a first electrode on a substrate; stacking a second electrode on the first electrode; providing a first surface that is of the second electrode and that is away from the first electrode with a first channel hole extending into the first electrode, where a part that is of a side wall of the first channel hole and that is located between the first electrode and the second electrode is concave in a direction parallel to the substrate to form a concave cavity, so that a side wall surface of the first channel hole is a concave wall surface; stacking a channel layer on the concave wall surface, so that the channel layer covers the concave wall surface; stacking a gate dielectric layer on the channel layer, so that the gate dielectric layer covers the channel layer; and stacking a gate on the gate dielectric layer, so that the gate covers the gate dielectric layer, to form, on the substrate, a transistor including the first electrode, the second electrode, the channel layer, the gate dielectric layer, and the gate.

It can be learned that, according to a chip prepared by using the preparation method provided in this embodiment of this application, the side wall surface of the first channel hole is the concave wall surface, and the channel layer is formed on the concave wall surface. In this way, a contact area between the channel layer and the first electrode and a contact area between the channel layer and the second electrode are increased, thereby improving a gate control capability, and increasing an on-state current of the chip.

In a feasible implementation of the second aspect, when the channel layer is formed, the channel layer is enabled to cover the first surface; when the gate dielectric layer is formed, the gate dielectric layer is enabled to cover the channel layer on the first surface; and when the gate is formed, the gate is enabled to cover the gate dielectric layer on the first surface.

In a feasible implementation of the second aspect, when the gate is formed, the gate, the gate dielectric layer, and the channel layer are enabled to fill the first channel hole.

After the channel layer and the gate dielectric layer are sequentially stacked in the first channel hole, and when the gate continues to be stacked, a remaining part of the first channel hole is filled, so that a structure is simple. This is easy to process, and facilitates array arrangement and production of the transistor.

In a feasible implementation of the second aspect, after the stacking a first electrode on a substrate, and before the stacking a second electrode on the first electrode, the preparation method further includes: stacking a dielectric layer on a side that is of the first electrode and that is away from the substrate; and the providing a first surface that is of the second electrode and that is away from the first electrode with a first channel hole extending into the first electrode includes: forming the concave cavity in the dielectric layer, where the concave cavity passes through the dielectric layer in a direction perpendicular to the substrate.

In a feasible implementation of the second aspect, when the concave cavity is formed in the dielectric layer, a boundary of an orthographic projection of the concave cavity on the substrate is enabled to be located within a boundary of an overlapping part between an orthographic projection of the first electrode on the substrate and an orthographic projection of the second electrode on the substrate; and when the channel layer is formed, a boundary of an orthographic projection of the channel layer on the substrate is enabled to be located within the boundary of the overlapping part between the orthographic projection of the first electrode on the substrate and the orthographic projection of the second electrode on the substrate.

In this way, for the prepared chip, not only the contact area between the channel layer and the first electrode and the contact area between the channel layer and the second electrode are increased; but also a volume of the transistor can be maintained in a small form, and the volume and performance of the transistor are considered.

In a feasible implementation of the second aspect, when the concave cavity is formed in the dielectric layer, a boundary of an orthographic projection of the concave cavity on the substrate is enabled to be located outside a boundary of an overlapping part between an orthographic projection of the first electrode on the substrate and an orthographic projection of the second electrode on the substrate; and when the channel layer is formed, a boundary of an orthographic projection of the channel layer on the substrate is enabled to be located outside the boundary of the overlapping part between the orthographic projection of the first electrode on the substrate and the orthographic projection of the second electrode on the substrate.

It can be learned from the foregoing embodiment that the channel layer is set as long as possible, and for the transistor prepared in this way, the contact area between the channel layer and the first electrode and the contact area between the channel layer and the second electrode are further increased, thereby further improving the gate control capability.

In a feasible implementation of the second aspect, the dielectric layer is etched through wet etching, so that the concave cavity extending in the direction perpendicular to the substrate is formed in the dielectric layer.

In a feasible implementation of the second aspect, after the stacking a first electrode on a substrate, and before the stacking a dielectric layer on a side that is of the first electrode and that is away from the substrate, the preparation method further includes: stacking a first doped layer on a surface that is of the first electrode and that is away from the substrate.

The transistor made of the first doped layer is disposed, so that ohmic contact between the first electrode and the channel layer is improved, and an on-state current of the transistor is further improved. In a feasible implementation of the second aspect, after the stacking a dielectric layer on a side that is of the first electrode and that is away from the substrate, and before the stacking a second electrode on a side that is of the first electrode and that is away from the substrate, the preparation method further includes: stacking a second doped layer on a surface that is of the dielectric layer and that is away from the first electrode.

The transistor made of the second doped layer is disposed, so that ohmic contact between the second electrode and the channel layer is improved, and an on-state current of the transistor is further improved.

In a feasible implementation of the second aspect, the providing a first surface that is of the second electrode and that is away from the first electrode with a first channel hole extending into the first electrode includes: providing the first surface that is of the second electrode and that is away from the first electrode with a plurality of first channel holes extending into the first electrode; the stacking a channel layer on the concave wall surface, stacking a gate dielectric layer on the channel layer, and stacking a gate on the gate dielectric layer includes: stacking the channel layer on the concave wall surface of each first channel hole; stacking the gate dielectric layer on each channel layer; and stacking the gate on each gate dielectric layer; and after the stacking a gate on the gate dielectric layer, the preparation method further includes: cutting off the transistor in the direction perpendicular to the substrate, to form a plurality of transistors including the first electrode, the second electrode, the channel layer, the gate dielectric layer, and the gate.

In this way, array arrangement and production of the transistors can be implemented.

In a feasible implementation of the second aspect, after the stacking a gate on the gate dielectric layer, the preparation method further includes: providing a second surface that is of the gate and that is away from the first electrode with a gap that sequentially passes through the gate, the gate dielectric layer, the channel layer, and the first electrode, and filling the gap with an insulating medium material, so that the chip is separated into a plurality of parts.

In this way, a volume of the prepared transistor is small, and integration of the transistor can be improved.

According to a third aspect, an electronic device is provided. The electronic device includes a printed circuit board and the chip according to the first aspect. The chip is disposed on the printed circuit board and is electrically connected to the printed circuit board.

In this way, a transistor that can implement a small volume (a small occupied area), a high gate control capability, a high on-state current, and high integration is disposed on the electronic device, so that overall performance of the electronic device is improved.

### BRIEF DESCRIPTION OF DRAWINGS

FIG. 1 is a diagram of a structure of a memory according to an embodiment of this application;
FIG. 2 is a diagram of a structure of a storage unit in the memory shown in FIG. 1;
FIG. 3 is a diagram of a structure of a chip according to an embodiment of this application;
FIG. 4a is a cross-sectional diagram of the chip shown in FIG. 3 after splitting;
FIG. 4b is a diagram of a structure of a concave wall surface of a first channel hole shown in FIG. 4a;
FIG. 5 is a cross-sectional diagram of the chip shown in FIG. 3;
FIG. 6a is a cross-sectional diagram of another chip according to an embodiment of this application;
FIG. 6b is a top view of the chip shown in FIG. 6a;
FIG. 7 is a cross-sectional diagram of a chip according to an embodiment of this application;
FIG. 8a is a cross-sectional diagram of still another chip according to an embodiment of this application;
FIG. 8b is a top view of an implementation of the chip shown in FIG. 8a;
FIG. 8c is a top view of another implementation of the chip shown in FIG. 8a;
FIG. 9a is a cross-sectional diagram of yet another chip according to an embodiment of this application;
FIG. 9b is a top view of an implementation of the chip shown in FIG. 9a;
FIG. 9c is a top view of another implementation of the chip shown in FIG. 9a;
FIG. 10a is a cross-sectional diagram of a chip according to an embodiment of this application;
FIG. 10b is a top view of an implementation of the chip shown in FIG. 10a;
FIG. 10c is a top view of another implementation of the chip shown in FIG. 10a;
FIG. 11 is a cross-sectional diagram of a chip according to an embodiment of this application;
FIG. 12 is a process flowchart of a chip preparation method according to an embodiment of this application;
FIG. 13 is a process structural diagram of a chip preparation method according to an embodiment of this application;
FIG. 14a is a process flowchart of a chip preparation method according to an embodiment of this application;
FIG. 14b is a process structural diagram of a chip preparation method according to an embodiment of this application;
FIG. 14c is a process structural diagram of a chip preparation method according to an embodiment of this application;
FIG. 15 is a process structural diagram of a chip preparation method according to an embodiment of this application;
FIG. 16a is a process flowchart of a chip preparation method according to an embodiment of this application;
FIG. 16b is a process structural diagram of a chip preparation method according to an embodiment of this application;
FIG. 16c is a process structural diagram of a chip preparation method according to an embodiment of this application;
FIG. 17a is a process structural diagram of a chip preparation method according to an embodiment of this application;
FIG. 17b is a process structural diagram of a chip preparation method according to an embodiment of this application;
FIG. 18 is a process flowchart of a chip preparation method according to an embodiment of this application;
FIG. 19a is a process structural diagram of a chip preparation method according to an embodiment of this application;
FIG. 19b is a process structural diagram of a chip preparation method according to an embodiment of this application;
FIG. 19c is a process structural diagram of a chip preparation method according to an embodiment of this application;
FIG. 19d is a process structural diagram of a chip preparation method according to an embodiment of this application;
FIG. 20a is a process structural diagram of a chip preparation method according to an embodiment of this application;
FIG. 20b is a process structural diagram of a chip preparation method according to an embodiment of this application;
FIG. 20c is a process structural diagram of a chip preparation method according to an embodiment of this application;
FIG. 21 is a process structural diagram of a chip preparation method according to an embodiment of this application;
FIG. 22 is a process structural diagram of a chip preparation method according to an embodiment of this application;
FIG. 23 is a process structural diagram of a chip preparation method according to an embodiment of this application;
FIG. 24 is a process structural diagram of a chip preparation method according to an embodiment of this application;
FIG. 25 is a process structural diagram of a chip preparation method according to an embodiment of this application; and
FIG. 26 is a process structural diagram of a chip preparation method according to an embodiment of this application.

Reference numerals:
10: memory; 12: storage unit; 12a1: first transistor; 12a2: second transistor; 100: chip; 1001: substrate; 1002: transistor; 110: gate; 110a: U-shaped groove; 110b: upper surface; 110c: lower surface; 120: gate dielectric layer; 130: channel layer; 130a: first part; 130b: second part; 130c: third part; 130d: fourth part; 140: second electrode; 140a: first surface; 140a1: first overlapping part; 140a2: second overlapping part; 140a3: third overlapping part; 140a4: fourth overlapping part; 140b: second surface; 150: dielectric layer; 160: first electrode; 160a: third surface; 1003: first channel hole; 1003a: upper hole; 1003a1: first wall surface; 1003b: concave cavity; 1003b1: second wall surface; 1003b2: third wall surface; 1003b3: fourth wall surface; 1003c: lower hole; 1003c1: fifth wall surface; 1003c2: sixth wall surface; 1003s: concave wall surface; 1004: overlapping part; 1005: gap; 1006: fourth groove.

### DESCRIPTION OF EMBODIMENTS

The following describes technical solutions in embodiments of this application with reference to accompanying drawings in embodiments of this application. In descriptions of this application, "/" indicates an "or" relationship between associated objects unless otherwise specified. For example, A/B may indicate A or B. The term "and/or" in this application describes only an association relationship between associated objects and indicates that three relationships may exist. For example, A and/or B may indicate the following three cases: Only A exists, both A and B exist, and only B exists, where A and B may be singular or plural. In addition, in the descriptions of this application, "a plurality of" means two or more than two unless otherwise specified. "At least one of the following items (pieces)" or a similar expression thereof means any combination of these items, including any combination of singular items (pieces) or plural items (pieces). For example, at least one item (piece) of a, b, or c may indicate: a, b, c, a and b, a and c, b and c, or a, b, and c, where a, b, and c may be singular or plural. In addition, to clearly describe the technical solutions in embodiments of this application, terms such as "first" and "second" are used in embodiments of this application to distinguish between same items or similar items that provide basically same functions or purposes. A person skilled in the art may understand that the terms such as "first" and "second" do not limit a quantity or an execution sequence, and the terms such as "first" and "second" do not indicate a definite difference. In addition, in embodiments of this application, the term such as "example" or "for example" is used to represent giving an example, an illustration, or a description. Any embodiment or design scheme described as an "example" or "for example" in embodiments of this application should not be explained as being more preferred or having more advantages than another embodiment or design scheme. Exactly, use of the term such as "example" or "for example" is intended to present a related concept in a specific manner for ease of understanding.

An electronic device provided in embodiments of this application may be a computer device having a TFT-type display, or may be a mobile phone, a wearable device, or the like having a TFT-type screen. A specific form of the electronic device is not particularly limited in embodiments of this application.

Each liquid crystal pixel on the TFT-type display or the TFT-type screen is driven by a TFT integrated behind the pixel. For example, the electronic device includes a printed circuit board and a chip. The chip is disposed on the printed circuit board and is electrically connected to the printed circuit board, to support the chip to implement a driving operation. The chip includes a transistor, and the transistor is configured to drive a pixel to be displayed.

The chip may be used in an electronic device having a TFT-type display or a TFT-type screen, or may be disposed on the electronic device as a memory.

The following uses the memory as an example to describe in detail the chip provided in this application.

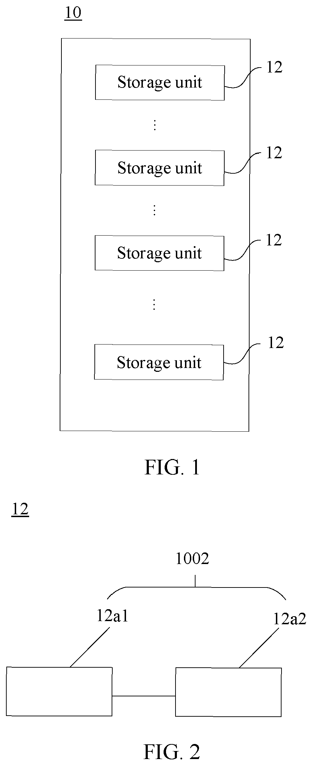

FIG. 1 is a diagram of a structure of a memory according to an embodiment of this application. As shown in FIG. 1, in some embodiments, the memory 10 includes a plurality of storage units 12.

The storage unit 12 is configured to implement reading/writing of "0" and "1". The storage unit 12 may have a plurality of structure forms.

For example, as shown in FIG. 2, the storage unit 12 of the memory 10 includes two transistors 1002 (a first transistor 12a1 and a second transistor 12a2), and the memory of this type is a 2T0C memory. Specifically, the first transistor 12a1 may be configured to read data, and data reading/writing of the first transistor 12a1 may be enabled by applying a positive voltage to the first transistor 12a1. The second transistor 12a2 may be configured to write data, may inject a charge by applying a positive voltage to the second transistor 12a2, and extract a charge by applying a negative voltage to the second transistor 12a2. A gate of the first transistor 12a1 is electrically in contact with a drain of the second transistor 12a2, and a charge in the first transistor 12a1 is changed via the second transistor 12a2, thereby affecting an impedance state between a source and a drain of the first transistor 12a1, and implementing reading/writing of "0" and "1".

For another example, the storage unit 12 of the memory 10 includes one capacitor and one transistor 1002. The capacitor is configured to store a charge, the transistor 1002 is configured to access the capacitor, and the transistor 1002 may read a quantity of charges stored in the capacitor, to implement reading/writing of "0" and "1" by the storage unit 12. The memory of this type is a 1T1C memory.

It may be understood that FIG. 1 shows only an example of some components included in the memory, and actual shapes, actual sizes, actual positions, and actual construction of these components are not limited in FIG. 1.

As an important component of the storage unit 12, the transistor 1002 affects storage density and a reading/writing speed of the memory 10. Embodiments of this application provide a chip. The chip may be used as a memory. The chip has a high gate control capability and a large on-state current, and may further implement stacking integration of a plurality of devices, to improve storage density and a reading/writing speed of the memory.

The following describes in detail the chip provided in embodiments of this application with reference to the accompanying drawings.

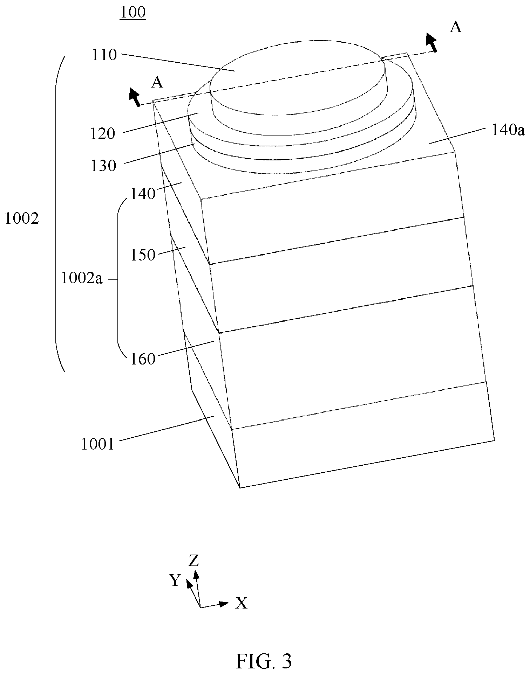

FIG. 3 is a diagram of a structure of a chip according to an embodiment of this application. As shown in FIG. 3, in some embodiments, the chip 100 includes a substrate 1001 and a transistor 1002 formed on the substrate 1001. The transistor 1002 includes a first electrode 160, a dielectric layer 150, and a second electrode 140. The first electrode 160, the dielectric layer 150, and the second electrode 140 are sequentially stacked on the substrate 1001.

The transistor 1002 shown in FIG. 3 may be used in the 2T0C memory shown in FIG. 2, and is used as the first transistor 12a1 and/or the second transistor 12a2. In another structure, the transistor 1002 shown in FIG. 3 may alternatively be used in a 1T1C memory.

In some implementations, the first electrode 160, the dielectric layer 150, and the second electrode 140 may be formed on the substrate 1001 through a deposition process. For example, the first electrode 160, the dielectric layer 150, and the second electrode 140 may be formed through a chemical vapor deposition (CVD) process, a physical vapor deposition (PVD) process, an atomic layer deposition (ALD) process, and the like.

A material of the substrate 1001 may include at least one of monocrystalline silicon (Si), monocrystalline germanium (Ge), gallium arsenide, indium phosphide, an III-V compound semiconductor material, an II-VI compound semiconductor material, or another semiconductor material known in the art, or may be made of a non-conductive material such as glass, plastic, or a sapphire wafer.

In addition, the dielectric layer 150 may be made of a plurality of materials, and may be made of an insulating medium, for example, may be made of a silicon oxide (SiOx), a silicon nitride (SiNx), an aluminum oxide (Al₂O₃), hafnium oxide (HfO₂), zirconium dioxide (ZrO₂), titanium dioxide (TiO₂), yttrium oxide (Y₂O₃), or a composite material, a stacked material, or a composite stacked material thereof.

In addition, the first electrode 160 and the second electrode 140 are used as a source and a drain of the transistor 1002, an electrode that receives an external signal is used as the source, and an electrode that outputs a signal is referred to as the drain. For example, the first electrode 160 may be used as a source that receives an external signal, and the second electrode 140 may be used as a drain that outputs a signal. For another example, the second electrode 140 may be used as a source that receives an external signal, and the first electrode 160 may be used as a drain that outputs a signal.

The first electrode 160 and the second electrode 140 may be made of a plurality of materials, and may be made of a metal material or a conductive material, for example, may be made of titanium nitride (TiN), titanium (Ti), gold (Au), tungsten (W), molybdenum (Mo), indium tin oxide (In-Ti-O, ITO), indium zinc oxide (In-Zn-O, IZO), aluminum (Al), copper (Cu), ruthenium (Ru), silver (Ag), platinum (Pt), or any combination thereof.

In this way, the first electrode 160, the dielectric layer 150, and the second electrode 140 are sequentially stacked on the substrate 1001, to form a metal-insulating medium-metal stacked structure 1002a. Based on this, the first electrode 160 and the second electrode 140 are isolated through the dielectric layer 150, and the dielectric layer 150 can implement electrical isolation between the first electrode 160 and the second electrode 140.

For ease of description below, a direction perpendicular to the substrate 1001 is defined as a Z-axis direction, and a plane parallel to the substrate 1001 is an XY plane.

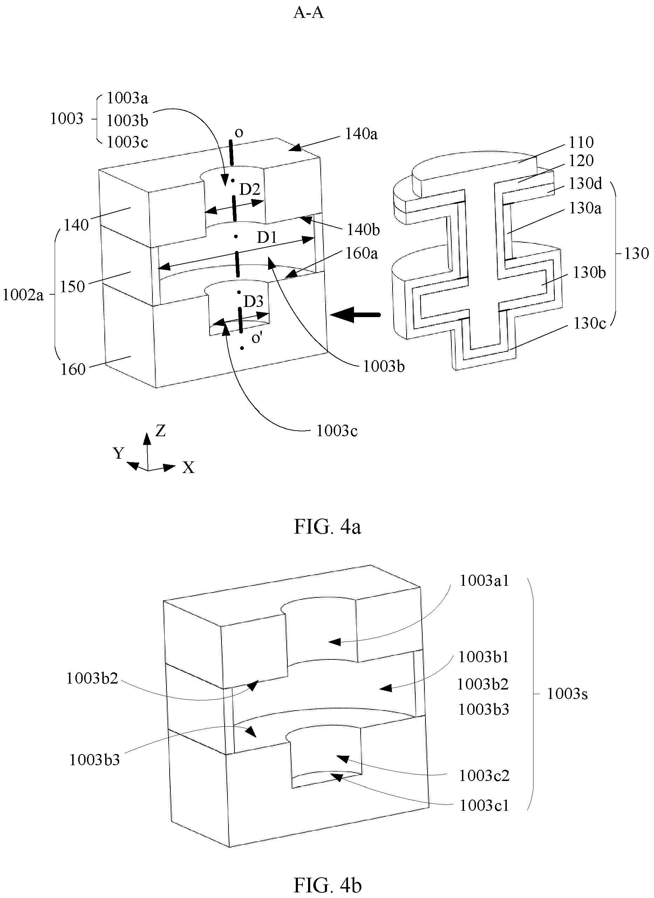

Still refer to FIG. 3. The transistor 1002 further includes a channel layer 130, a gate dielectric layer 120, and a gate 110. The following describes structures of the channel layer 130, the gate dielectric layer 120, and the gate 110 in the chip 100 with reference to FIG. 4a.

FIG. 4a is a cross-sectional diagram of the chip shown in FIG. 3 after splitting. As shown in FIG. 4a, a first channel hole 1003 is formed in the stacked structure 1002a.

As shown in FIG. 4a, in some embodiments, the second electrode 140 has a first surface 140a away from the first electrode 160, and the first channel hole 1003 extends from the first surface 140a into the first electrode 160. A part that is of a side wall of the first channel hole 1003 and that is located between the first electrode 160 and the second electrode 140 is concave in a direction parallel to the substrate (namely, the XY direction) to form a concave cavity 1003b, so that the side wall surface of the first channel hole 1003 is a concave wall surface 1003s.

The concave cavity 1003b may be formed by etching the dielectric layer 150. For example, the concave cavity 1003b that passes through the dielectric layer 150 in the direction perpendicular to the substrate (the Z direction) may be formed in the dielectric layer 150. Because the dielectric layer 150 is a material different from the first electrode 160 and the second electrode 140, when the stacked structure 1002a is etched, only the dielectric layer 150 may be selectively etched, and the first electrode 160 and the second electrode 140 are not etched, to form the concave cavity 1003b. For example, only the material of the dielectric layer 150 may be removed through a wet etching process, and the materials of the first electrode 160 and the second electrode 140 are no longer removed. The dielectric layer 150 not only can implement electrical isolation between the first electrode 160 and the second electrode 140, but also can avoid a carrier diffusion phenomenon at a contact position between the first electrode 160 and the channel layer 130 and a contact position between the second electrode 140 and the channel layer 130, thereby avoiding electric leakage.

Based on this, as shown in FIG. 4a, the first channel hole 1003 includes an upper hole 1003a, the concave cavity 1003b, and a lower hole 1003c that are connected to each other. As shown in FIG. 4b, the concave wall surface 1003s includes a first wall surface 1003a1 of the upper hole 1003a, a second wall surface 1003b1 of the concave cavity 1003b, a third wall surface 1003b2 of the concave cavity 1003b, a fourth wall surface 1003b3 of the concave cavity 1003b, a fifth wall surface 1003c1 of the lower hole 1003c, and a sixth wall surface 1003c2 of the lower hole 1003c.

The upper hole 1003a is located in the second electrode 140, and passes through the second electrode 140 in the Z direction.

The concave cavity 1003b is located between the first electrode 160 and the second electrode 140. The second electrode 140 has a second surface 140b opposite to the first surface 140a in the Z direction, and a part of a region of the second surface 140b is used as an upper wall surface of the concave cavity 1003b. The first electrode 160 has a third surface 160a close to the second electrode 140, and a part of a region of the third surface 160a is used as a lower wall surface of the concave cavity 1003b. A boundary of an orthographic projection of a side wall surface (namely, a wall surface parallel to the Z direction) of the concave cavity 1003b on the XY plane (parallel to the plane of the substrate 1001) is located outside a boundary of an orthographic projection of the upper hole 1003a on the XY plane. For example, when the upper hole 1003a is a circular hole shown in FIG. 4a, and the concave cavity 1003b is a circular hole shown in FIG. 4a, the concave cavity 1003b and the upper hole 1003a may be circular holes of a coaxial line (an axis o-o'), and a diameter D1 of the concave cavity 1003b is greater than a diameter D2 of the upper hole 1003a.

The lower hole 1003c is located in the first electrode 160, and the lower hole 1003c does not pass through the first electrode 160. For example, the lower hole 1003c may be a circular hole shown in FIG. 4a, and a diameter D3 of the lower hole 1003c may be equal to the diameter D2 of the upper hole 1003a.

The upper hole 1003a, the concave cavity 1003b, and the lower hole 1003c may be circular holes shown in FIG. 4a, or may be square holes whose cross sections parallel to the XY plane are squares, or may be tapered holes. A shape of a cross section that is of the first channel hole 1003 and that is parallel to the XY plane is not limited in this application.

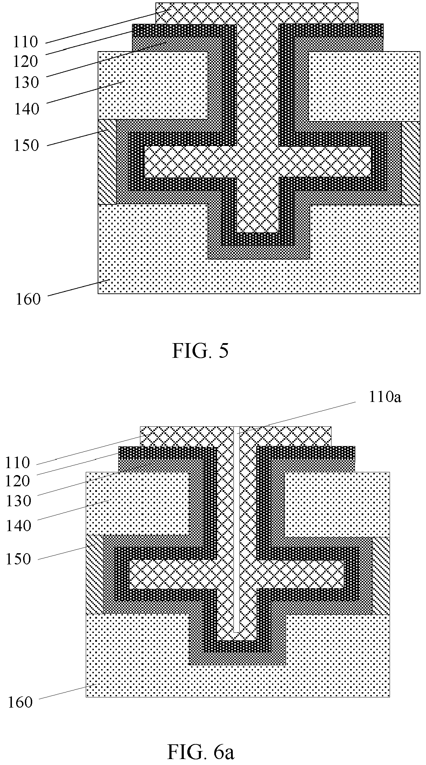

To enable the first electrode 160 and the second electrode 140 to be in electrical contact with the channel layer 130, the channel layer 130 is stacked on the concave wall surface 1003s of the first channel hole 1003. FIG. 5 is a cross-sectional diagram of the chip shown in FIG. 3.

With reference to FIG. 4a, FIG. 4b, and FIG. 5, the channel layer 130 includes a first part 130a formed on the first wall surface 1003a1 of the upper hole 1003a, a second part 130b formed on the second wall surface 1003b1 of the concave cavity 1003b, the third wall surface 1003b2 of the concave cavity 1003b, and the fourth wall surface 1003b3 of the concave cavity 1003b, and a third part 130c formed on the fifth wall surface 1003c1 of the lower hole 1003c and the sixth wall surface 1003c2 of the lower hole 1003c.

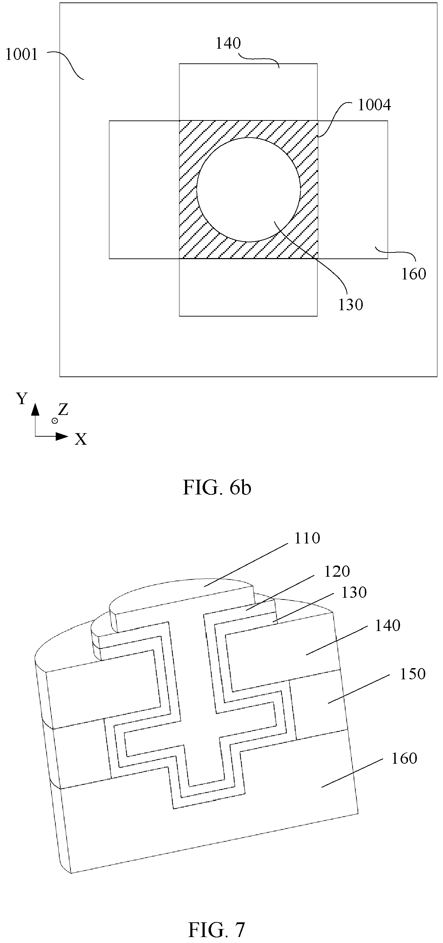

FIG. 6a is a cross-sectional diagram of another chip according to an embodiment of this application. FIG. 6b is a top view of the chip shown in FIG. 6a. As shown in FIG. 6a and FIG. 6b, in some embodiments, a boundary of an orthographic projection, on the substrate 1001, of a part that is of the channel layer 130 and that is located between the first electrode 160 and the second electrode 140 is located within a boundary of an overlapping part 1004 between an orthographic projection of the first electrode 160 on the substrate 1001 and an orthographic projection of the second electrode 140 on the substrate 1001.

The channel layer 130 may be made of a plurality of materials, for example, may be a silicon-based semiconductor such as silicon (Si), doped polycrystalline silicon (poly-Si), or amorphous silicon (amorphous-Si), or metal oxide such as indium oxide (In₂O₃), zinc oxide (ZnO), gallium oxide (Ga₂O₃), ITO, or titanium oxide (TiO₂), or may be multi-compound such as indium gallium zinc oxide (In-Ga-Zn-O, IGZO) or indium tin zinc oxide (In-Sn-Zn-O, ISZO), or may be a two-dimensional semiconductor material such as graphene, molybdenum sulfide (MoS₂), or black phosphorus, or any combination thereof.

Based on this, in comparison with that the channel layer 130 is disposed only on the first wall surface 1003a1 of the upper hole 1003a, the fifth wall surface 1003c1 of the lower hole 1003c, and the sixth wall surface 1003c2 of the lower hole 1003c, in this embodiment of this application, the channel layer 130 is further disposed on the third wall surface 1003b2 of the concave cavity 1003b and the fourth wall surface 1003b3 of the concave cavity 1003b. The channel layer 130 is disposed on the third wall surface 1003b2 of the concave cavity 1003b, so that a contact area between the channel layer 130 and the second electrode 140 is increased. The channel layer 130 is disposed on the fourth wall surface 1003b3 of the concave cavity 1003b, so that a contact area between the channel layer 130 and the first electrode 160 is increased. Therefore, the chip 100 provided in embodiments of this application improves a gate control capability, and increases the on-state current of the chip 100.

In this case, according to the chip 100 provided in embodiments of this application, the contact area between the channel layer 130 and the first electrode 160 and the contact area between the channel layer 130 and the second electrode 140 are increased, and an area of an orthographic projection of the transistor 1002 on the substrate 1001 is not increased. Therefore, an occupied area of the transistor 1002 is reduced, thereby facilitating implementation of high integration of the transistor 1002 while performance is ensured. Such a chip 100 is used in the memory 10, so that storage density of the memory 10 can be improved, and a storage delay can be effectively reduced.

In addition, to implement electrical isolation between the channel layer 130 and the gate 110, the channel layer 130 and the gate 110 are isolated through the gate dielectric layer 120. In addition, the gate dielectric layer 120 can further implement electrical isolation between the first electrode 160 and the gate 110, and electrical isolation between the second electrode 140 and the gate 110.

The gate dielectric layer 120 may be made of a plurality of materials, and may be made of an insulating medium, for example, may be made of a silicon oxide (SiOx), a silicon nitride (SiNx), an aluminum oxide (Al₂O₃), hafnium oxide (HfO₂), zirconium dioxide (ZrO₂), titanium dioxide (TiO₂), yttrium oxide (Y₂O₃), or a composite material, a stacked material, or a composite stacked material thereof.

The gate 110 may be made of a plurality of materials, and may be made of a metal material or a conductive material, for example, may be TiN, Ti, Au, W, Mo, ITO, IZO, Al, Cu, Ru, Ag, Pt, or any combination thereof.

In addition, a structure of the gate 110 may be implemented in a plurality of manners. For example, the gate 110 shown in FIG. 5 may fill the first channel hole 1003. In this way, the gate 110 is easy to process, and facilitates array arrangement and production of the transistor 1002. For another example, the gate 110 shown in FIG. 6a may not fill the first channel hole 1003, but forms a U-shaped groove 110a in the first channel hole 1003. The U-shaped groove 110a may be configured to fill an insulating medium, to implement isolation between devices of the transistor 1002. A shape of the gate 110 is not limited in this application.

To further increase the contact area between the channel layer 130 and the second electrode 140, in some embodiments, in addition to being stacked on the concave wall surface 1003s of the channel layer 130, the channel layer 130 further includes a fourth part 130d covering the first surface 140a of the second electrode 140. In an implementation, the fourth part 130d is covered with the gate dielectric layer 120, and the gate dielectric layer 120 is covered with the gate 110, to implement electrical isolation between the fourth part 130d of the channel layer 130 and the gate 110.

According to the chip 100 provided in the foregoing embodiments, the contact area between the channel layer 130 and the first electrode 160 and the contact area between the channel layer 130 and the second electrode 140 are further increased, and the area of an orthographic projection of the transistor 1002 on the substrate 1001 is not increased. Therefore, the occupied area of the transistor 1002 is reduced, thereby facilitating implementation of high integration of the transistor 1002 while performance is ensured.

The chip 100 provided in embodiments of this application may have a plurality of shapes. For example, the chip 100 may be in a square shape shown in FIG. 3, or may be in a cylindrical shape shown in FIG. 7, or may be in another regular or irregular polygon shape. The shape of the chip 100 is not limited in this application.

To obtain a larger width of the channel layer and increase a contact area between the channel layer and the source and a contact area between the channel layer and the drain, this application further provides the following several implementations of the chip 100. The following describes the plurality of implementations of the chip 100 with reference to the accompanying drawings.

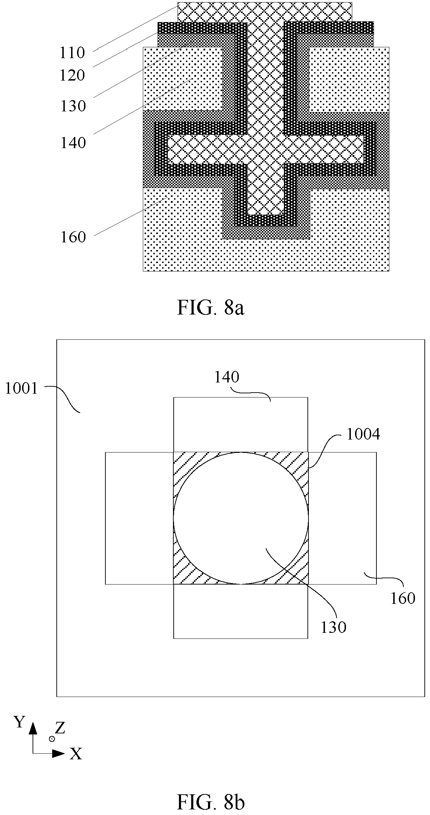

FIG. 8a is a cross-sectional diagram of a chip according to an embodiment of this application. As shown in FIG. 8a, in some embodiments, at least a part of a boundary of an orthographic projection, on the substrate 1001, of a part that is of the channel layer 130 and that is located between the first electrode 160 and the second electrode 140 is located on a boundary of an overlapping part 1004 between an orthographic projection of the first electrode 160 on the substrate 1001 and an orthographic projection of the second electrode 140 on the substrate 1001. The following provides two specific implementations.

FIG. 8b is a top view of an implementation of the chip shown in FIG. 8a. As shown in FIG. 8b, in an implementation, a cross section that is of the channel layer 130 and that is parallel to the XY plane is a circle, and an edge of the channel layer 130 is tangent to an edge of an overlapping part 1004 between an orthographic projection of the first electrode 160 on the substrate 1001 and an orthographic projection of the second electrode 140 on the substrate 1001.

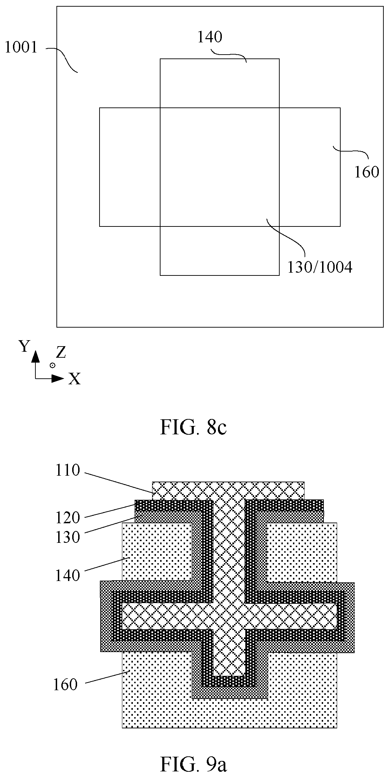

FIG. 8c is a top view of another implementation of the chip shown in FIG. 8a. As shown in FIG. 8c, in another implementation, a cross section that is of the channel layer 130 and that is parallel to the XY plane in the Z direction is a square, and an edge of the channel layer 130 overlaps an edge of an overlapping part 1004 between an orthographic projection of the first electrode 160 on the substrate 1001 and an orthographic projection of the second electrode 140 on the substrate 1001. In this case, the contact area between the channel layer 130 and the first electrode 160 and the contact area between the channel layer 130 and the second electrode 140 are larger.

In this way, when the contact area between the channel layer 130 and the first electrode 160 and the contact area between the channel layer 130 and the second electrode 140 are increased, a volume of the transistor is not increased, and the volume and performance of the transistor are considered.

In some scenarios, the contact area between the channel layer 130 and the first electrode 160 and the contact area between the channel layer 130 and the second electrode 140 can be further increased. FIG. 9a is a cross-sectional diagram of yet another chip according to an embodiment of this application.

As shown in FIG. 9a, in an implementation, a boundary of an orthographic projection, on the substrate, of a part that is of the channel layer and that is located between the first electrode and the second electrode is located outside a boundary of an overlapping part between an orthographic projection of the first electrode on the substrate and an orthographic projection of the second electrode on the substrate.

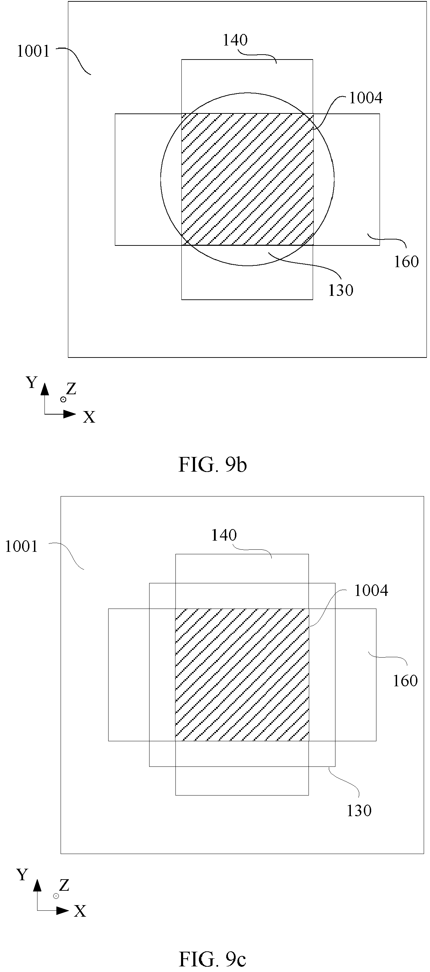

FIG. 9b is a top view of an implementation of the chip shown in FIG. 9a. As shown in FIG. 9b, in an implementation, a cross section that is of the channel layer 130 and that is parallel to the XY plane is a circle, and at least a part of a boundary of the channel layer 130 is located outside a boundary of an overlapping part 1004 between an orthographic projection of the first electrode 160 on the substrate 1001 and an orthographic projection of the second electrode 140 on the substrate 1001.

FIG. 9c is a top view of another implementation of the chip shown in FIG. 9a. As shown in FIG. 9c, in another implementation, a cross section that is of the channel layer 130 and that is parallel to the XY plane in the Z direction is a square, and a boundary of the channel layer 130 is located outside a boundary of an overlapping part 1004 between an orthographic projection of the first electrode 160 on the substrate 1001 and an orthographic projection of the second electrode 140 on the substrate 1001. In this case, the contact area between the channel layer 130 and the first electrode 160 and the contact area between the channel layer 130 and the second electrode 140 are larger.

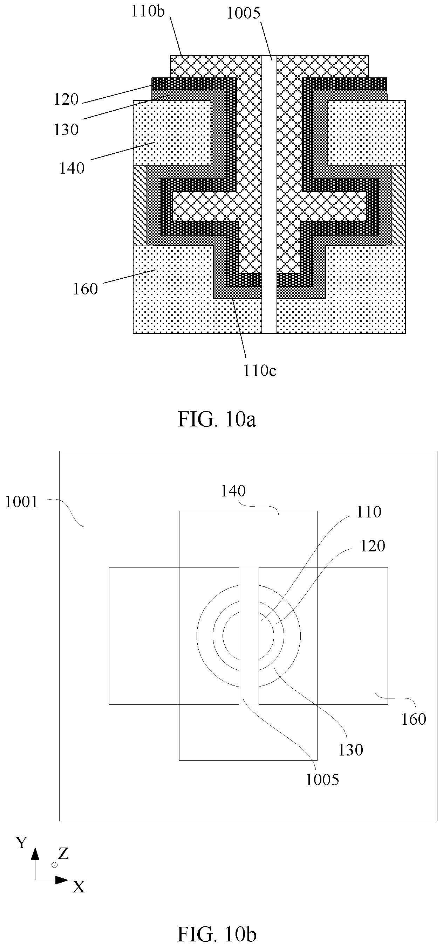

In addition, to reduce an occupied area of the transistor, that is, to reduce an orthographic projection area of the transistor on the substrate, this application provides a chip. FIG. 10a is a cross-sectional diagram of a chip according to an embodiment of this application.

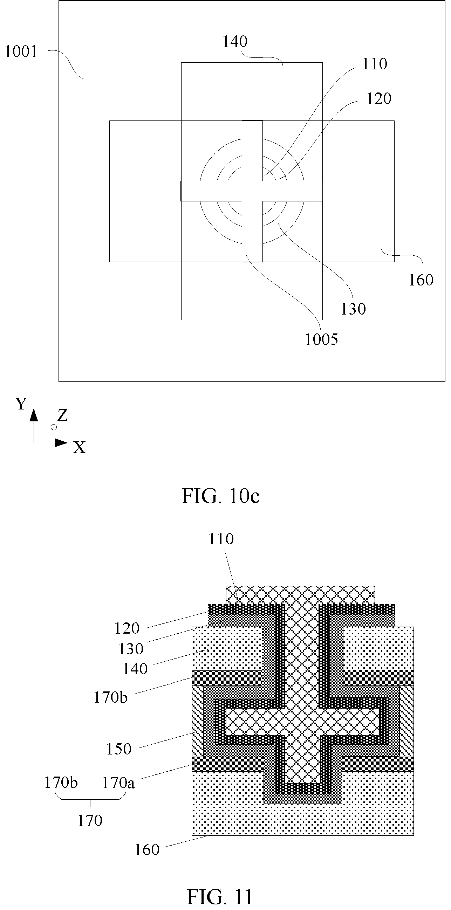

As shown in FIG. 10a, in some embodiments, the gate 110 has an upper surface 110b and a lower surface 110c that are located at two ends of the gate 110 in the direction (the Z direction) perpendicular to the substrate, the upper surface 110b is a surface that is of the gate 110 and that is away from the first electrode 160, the upper surface 110b is provided with a gap 1005 that sequentially passes through the gate 110, the gate dielectric layer 120, the channel layer 130, and the first electrode 160, and the gap 1005 is filled with an insulating medium material, to implement isolation between devices. For example, as shown in FIG. 10b, the gap 1005 may be in a long strip shape, and the transistor is divided into two parts. For example, as shown in FIG. 10c, the gap 1005 may be in a cross shape, and the transistor is divided into four parts.

To improve ohmic contact of the device and further improve an on-state current of the device, embodiments of this application provide the chip. In addition to the first electrode 160, the dielectric layer 150, the second electrode 140, the channel layer 130, the gate dielectric layer 120, and the gate 110, the chip further includes a doped layer.

FIG. 11 is a cross-sectional diagram of a chip according to an embodiment of this application. As shown in FIG. 11, in some embodiments, the chip further includes a first doped layer 170a, formed on a surface that is of the first electrode 160 and that is close to the second electrode 140, and located between the first electrode 160 and the channel layer 130. In this way, the first doped layer 170a and the channel layer 130 are in electrical contact, to improve ohmic contact.

Still refer to FIG. 11. In some embodiments, the chip further includes a second doped layer 170b, formed on a surface that is of the second electrode 140 and that is close to the first electrode 160, and located between the second electrode 140 and the channel layer 130. In this way, the second electrode 140 and the channel layer 130 are in electrical contact, to improve ohmic contact.

In addition, as shown in FIG. 11, the chip may include both the first doped layer 170a and the second doped layer 170b.

To increase a probability of bonding carriers (electrons and holes) and further improve an on-state current of the transistor, the first doped layer 170a, the second doped layer 170b, and a part that is of the channel layer 130 and that is located between the first doped layer 170a and the second doped layer 170b may be doped.

For example, N-type doping may be performed on the part that is of the channel layer 130 and that is located between the first doped layer 170a and the second doped layer 170b, and P⁺-type doping (where "+" marked in an upper right corner of P indicates that impurity doping concentration is relatively high compared with that of P-type doping) may be performed on the first doped layer 170a and the second doped layer 170b. A layer of low-doped N-type doping region (where the N region is generally very thin) is sandwiched between two high-doped P⁺-type doping regions, to form a PN junction, thereby increasing the probability of bonding carriers (electrons and holes) and further improve the on-state current of the transistor.

For another example, P-type doping may be performed on the part that is of the channel layer 130 and that is located between the first doped layer 170a and the second doped layer 170b, and N⁺-type doping (where "+" marked in an upper right corner of N indicates that impurity doping concentration is relatively high compared with that of N-type doping) may be performed on the first doped layer 170a and the second doped layer 170b. In this way, the part that is of the channel layer 130 and that is located between the first doped layer 170a and the second doped layer 170b is different from doping forms of both the first doped layer 170a and the second doped layer 170b, to implement PN junction contact, increase the probability of bonding carriers (electrons and electron holes), and further improve the on-state current of the transistor.

During doping, doping may be performed on only a part of a region of the first doped layer 170a, and doping may be performed on only a part of a region of the second doped layer 170b.

It may be understood that doping forms of the first doped layer 170a, the second doped layer 170b, and the part that is of the channel layer 130 and that is located between the first doped layer 170a and the second doped layer 170b include but are not limited to the foregoing two types, or may be another doping form. This is not limited in this application.

In addition, the chip provided in embodiments of this application may include a plurality of transistors that share the first electrode.

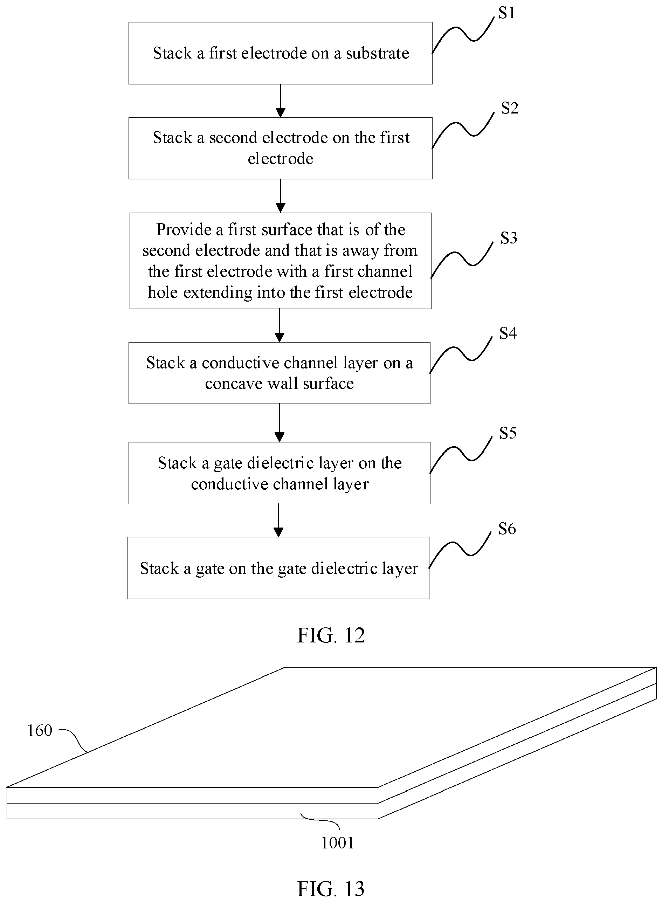

An embodiment of this application provides a chip preparation method. The following specifically describes an implementable chip preparation method with reference to a process flowchart shown in FIG. 12, a process structural diagram shown in FIG. 13, and the like. As shown in FIG. 12, the process flowchart includes steps S1 to S6.

S1: As shown in FIG. 13, stack a first electrode 160 on a substrate 1001.

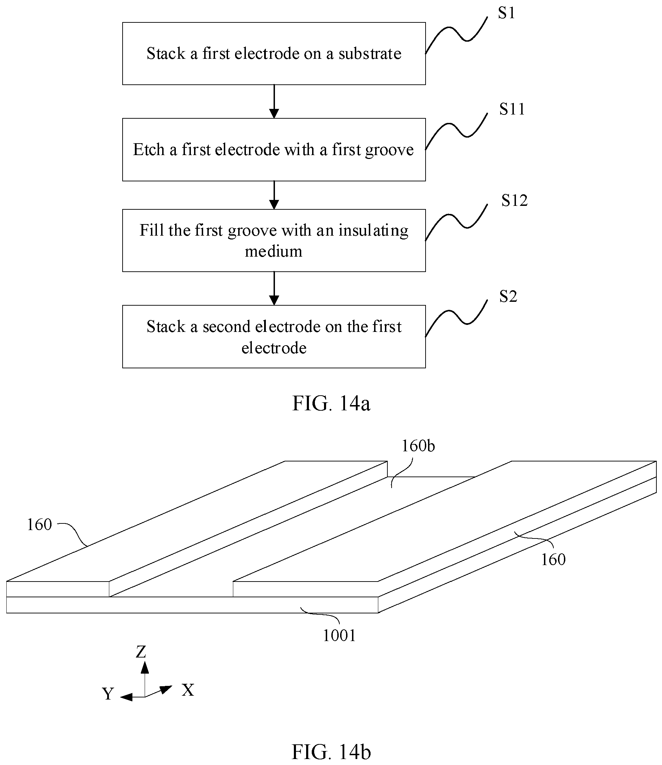

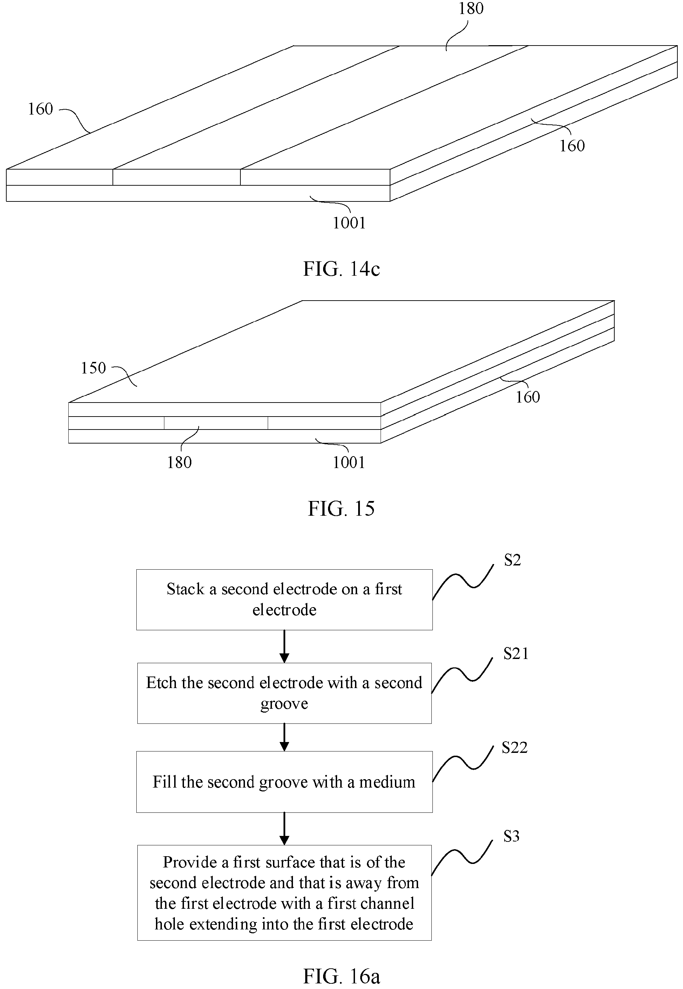

To implement array arrangement of a transistor, with reference to a process flowchart shown in FIG. 14a and process structural diagrams in FIG. 14b and FIG. 14c, in an implementation, after step S1 is performed and before step S2 is performed, the preparation method further includes steps S11 and S12.

S11: As shown in FIG. 14b, etch the first electrode 160 with a first groove 160b.

The first groove 160b extends in an X direction, and a shape of the first groove 160b may be in a square shape shown in FIG. 14b. In this way, the first electrode 160 is divided into a plurality of strip-shaped structures arranged in a Y direction from an entire strip shape.

S12: As shown in FIG. 14c, fill the first groove 160b with an insulating medium 180. The insulating medium 180 is used to implement electrical isolation between two adjacent strip-shaped first electrodes 160.

In addition, to implement electrical isolation between the first electrode 160 and a second electrode 140, after step S1 is performed or after step S12 is performed, and before step S2 is performed, the preparation method further includes step S13.

S13: As shown in FIG. 15, stack a dielectric layer 150 on the first electrode 160.

Still refer to FIG. 12.

S2: As shown in FIG. 15, stack the second electrode 140 on the first electrode 160.

In this way, after steps S1, S13, and S2 are performed, a metal-insulating medium-metal structure of the first electrode 160, the dielectric layer 150, and the second electrode 140 is formed, thereby implementing electrical isolation between the first electrode 160 and the second electrode 140.

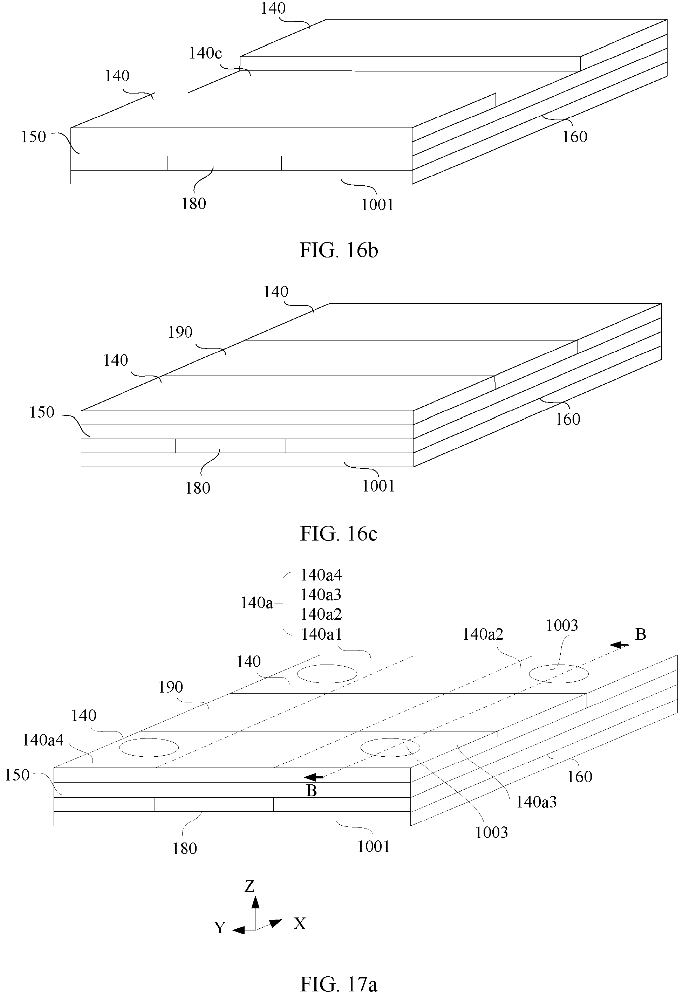

To implement array arrangement of a transistor, with reference to a process flowchart shown in FIG. 16a and process structural diagrams in FIG. 16b and FIG. 16c, in an implementation, after step S2 is performed and before step S3 is performed, the preparation method further includes steps S21 and S22.

S21: As shown in FIG. 16b, etch the second electrode 140 with a second groove 140c.

The second groove 140c extends in a Y direction, and a shape of the second groove 140c may be in a square shape shown in FIG. 16b. In this way, the second electrode 140 is divided into a plurality of strip-shaped structures arranged in an X direction from an entire strip shape.

In step S11, the first groove 160b extends in the X direction, and in step S21, the second groove 140c extends in the Y direction. The first electrode 160 and the second electrode 140 are both distributed in a strip shape, and disposed in a cross manner. In this way, during array arrangement, the plurality of transistors may share the first electrode 160 extending in the Y direction, and second electrodes 140 of the plurality of transistors that share the first electrode 160 are isolated.

S22: As shown in FIG. 16c, fill the second groove 140c with a medium 190. The medium 190 is used to implement electrical isolation between two adjacent strip-shaped second electrodes 140.

In this way, during array arrangement, electrical isolation between the second electrodes 140 of the plurality of transistors that share the first electrode 160 is implemented by filling the medium 190.

Still refer to FIG. 12.

S3: As shown in FIG. 17a, provide a first surface 140a that is of the second electrode 140 and that is away from the first electrode 160 with a first channel hole 1003 extending into the first electrode 160.

To implement array arrangement of the transistor, as shown in FIG. 17a, positions of first channel holes 1003 may be provided on a first overlapping part 140a1, a second overlapping part 140a2, a third overlapping part 140a3, and a fourth overlapping part 140a4 on the first surface 140a. The first overlapping part 140a1, the second overlapping part 140a2, the third overlapping part 140a3, and the fourth overlapping part 140a4 are parts in which the first electrode 160 and the second electrode 140 cross and overlap.

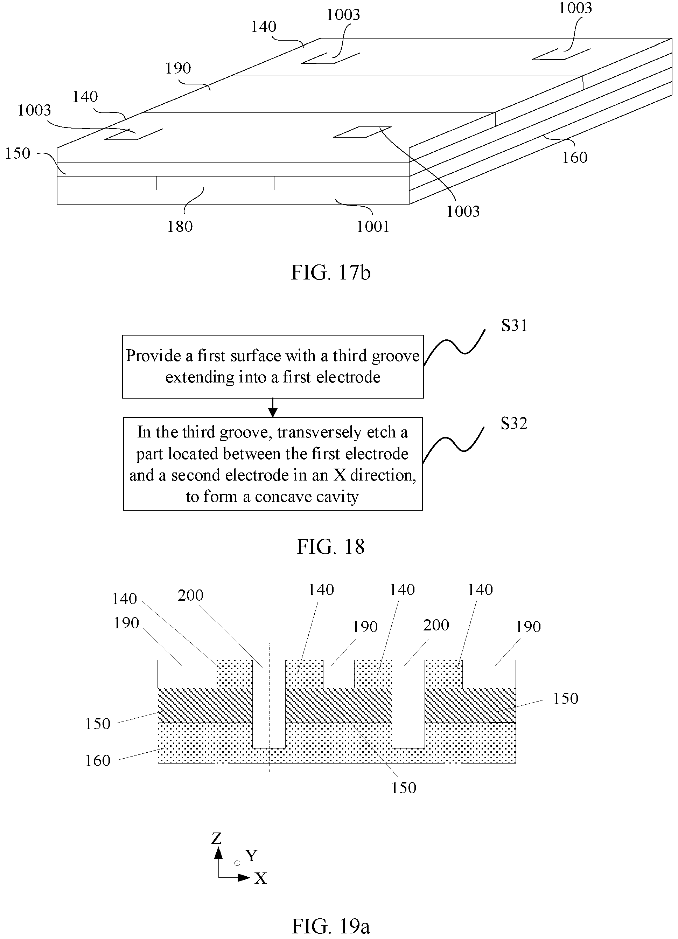

The first channel hole 1003 may be a circular hole shown in FIG. 17a, or may be a square hole shown in FIG. 17b.

Because the first channel hole 1003 is a hole structure having a concave wall surface, and the first channel hole 1003 sequentially passes through a metal-insulating medium-metal structure of the second electrode 140, the dielectric layer 150, and the first electrode 160, when step S3 is performed, with reference to a process flowchart shown in FIG. 18 and process structural diagrams in FIG. 19a to FIG. 19d, in an implementation, the preparation method may include step S31 and step S32.

Step S31: As shown in FIG. 19a, provide the first surface 140a with a third groove 200 extending into the first electrode 160. The third groove 200 is a straight hole in a Z direction.

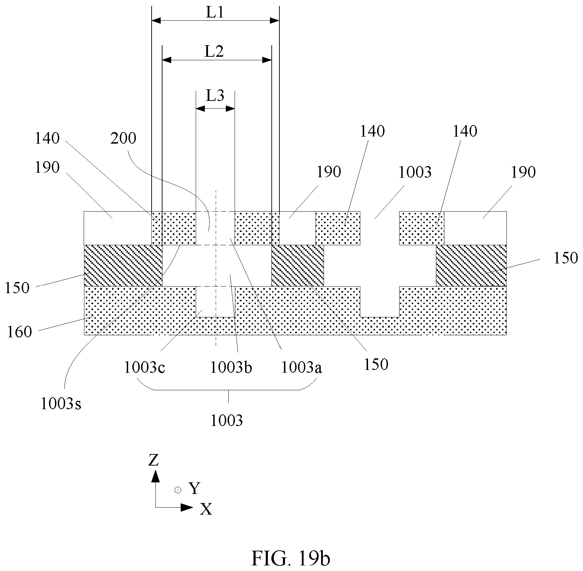

Step S32: As shown in FIG. 19b, in the third groove 200, transversely etch a part located between the first electrode 160 and the second electrode 140 in the X direction, to form a concave cavity 1003b; or a concave cavity 1003b that passes through the dielectric layer 150 in the direction (the Z direction) perpendicular to the substrate is provided in the dielectric layer 150.

In this way, the third groove 200 and the concave cavity 1003b jointly form the first channel hole 1003, so that the first channel hole 1003 is a hole structure that includes an upper hole 1003a, the concave cavity 1003b, and a lower hole 1003c and whose cross section parallel to an XZ surface is a cross. A side wall of the concave cavity 1003b is concave relative to a side wall of the third groove 200 in the direction (the Z direction) parallel to the substrate, so that a side wall of the first channel hole 1003 is a concave wall surface 1003s.

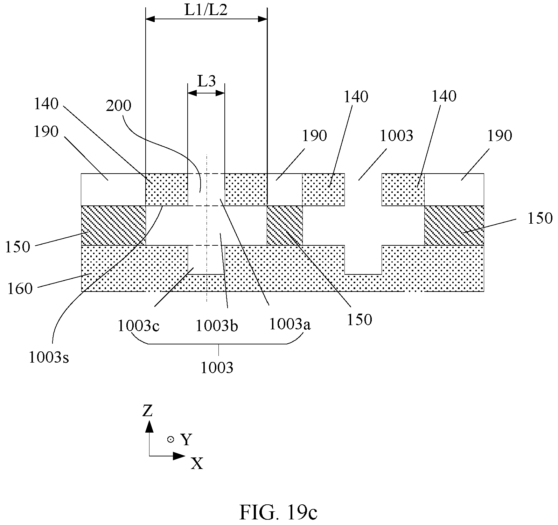

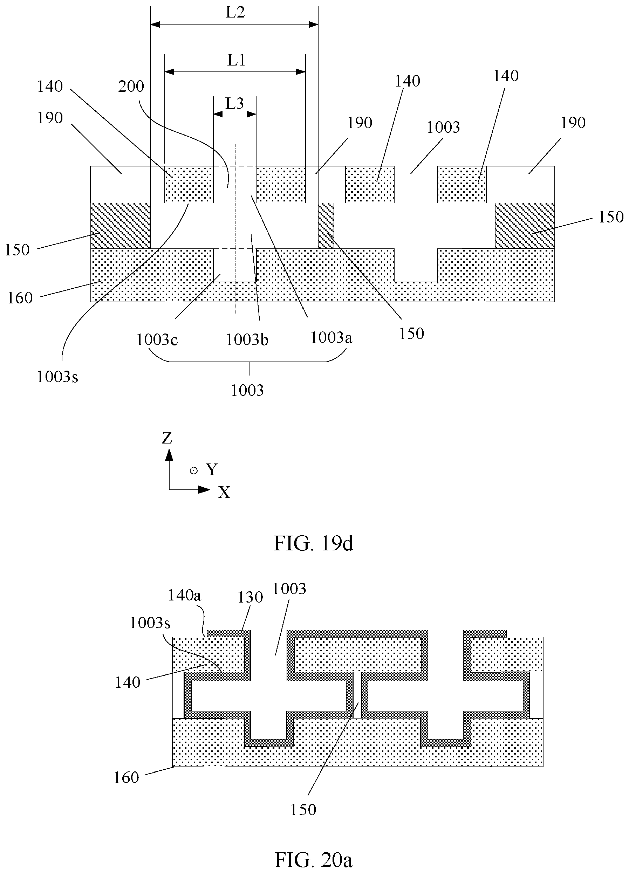

The following describes different implementations of the first channel hole 1003 with reference to FIG. 19b, FIG. 19c, and FIG. 19d.

In an implementation, as shown in FIG. 19b, a width L2 of the concave cavity 1003b of the first channel hole 1003 in the X direction is less than a width L1 of the second electrode 140 in the X direction. In this case, with reference to FIG. 17a, a boundary of an orthographic projection of the concave cavity 1003b on the substrate 1001 is located within a boundary of an overlapping part (namely, the first overlapping part 140a1, the second overlapping part 140a2, the third overlapping part 140a3, or the fourth overlapping part 140a4) between an orthographic projection of the first electrode 160 on the substrate 1001 and an orthographic projection of the second electrode 140 on the substrate 1001. For the transistor formed in this way, the first channel hole 1003 does not increase an occupied area of the transistor, so that a size requirement of the transistor can be met.

In another implementation, as shown in FIG. 19c, a width L2 of the concave cavity 1003b of the first channel hole 1003 in the X direction is equal to a width L1 of the second electrode 140 in the X direction. In this case, with reference to FIG. 17a, a boundary of an orthographic projection of the concave cavity 1003b on the substrate 1001 overlaps a boundary of an overlapping part (namely, the first overlapping part 140a1, the second overlapping part 140a2, the third overlapping part 140a3, or the fourth overlapping part 140a4) between an orthographic projection of the first electrode 160 on the substrate 1001 and an orthographic projection of the second electrode 140 on the substrate 1001. For the transistor formed in this way, the first channel hole 1003 does not increase an occupied area of the transistor, so that on a premise that a size requirement of the transistor is met, the width of the first channel hole 1003 is maximized.

In still another implementation, as shown in FIG. 19d, a width L2 of the concave cavity 1003b of the first channel hole 1003 in the X direction is greater than a width L1 of the second electrode 140 in the X direction. In this case, with reference to FIG. 17a, a boundary of an orthographic projection of the concave cavity 1003b on the substrate 1001 is located outside a boundary of an overlapping part (namely, the first overlapping part 140a1, the second overlapping part 140a2, the third overlapping part 140a3, or the fourth overlapping part 140a4) between an orthographic projection of the first electrode 160 on the substrate 1001 and an orthographic projection of the second electrode 140 on the substrate 1001. The transistor formed in this way further increases the width of the first channel hole 1003.

Still refer to FIG. 12.

S4: As shown in FIG. 20a, stack a channel layer 130 on the concave wall surface 1003s of the first channel hole 1003.

In an implementation, as shown in FIG. 20a, the channel layer 130 is stacked on the concave wall surface 1003s of the first channel hole 1003 shown in FIG. 19b. In this case, with reference to FIG. 17a, a boundary of an orthographic projection of the channel layer 130 on the substrate 1001 is located within a boundary of an overlapping part (namely, the first overlapping part 140a1, the second overlapping part 140a2, the third overlapping part 140a3, or the fourth overlapping part 140a4) between an orthographic projection of the first electrode 160 on the substrate 1001 and an orthographic projection of the second electrode 140 on the substrate 1001. For the transistor formed in this way, the channel layer 130 does not increase an occupied area of the transistor, so that on a premise that a size requirement of the transistor is met, a width of the channel layer 130 is increased, and a contact area between the channel layer 130 and the first electrode 160 and a contact area between the channel layer 130 and the second electrode 140 are increased.

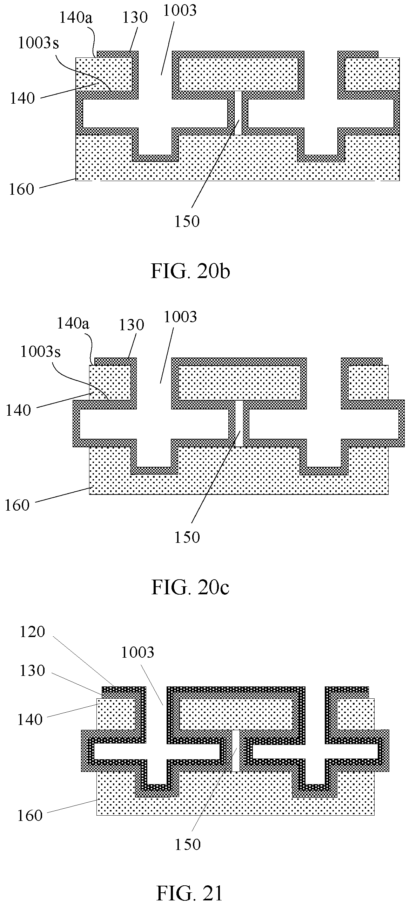

In an implementation, as shown in FIG. 20b, the channel layer 130 is stacked on the concave wall surface 1003s of the first channel hole 1003 shown in FIG. 19c. In this case, with reference to FIG. 17a, a boundary of an orthographic projection of the channel layer 130 on the substrate 1001 overlaps a boundary of an overlapping part (namely, the first overlapping part 140a1, the second overlapping part 140a2, the third overlapping part 140a3, or the fourth overlapping part 140a4) between an orthographic projection of the first electrode 160 on the substrate 1001 and an orthographic projection of the second electrode 140 on the substrate 1001. For the transistor formed in this way, the channel layer 130 does not increase an occupied area of the transistor, so that on a premise that a size requirement of the transistor is met, a width of the channel layer 130 is maximized, and a contact area between the channel layer 130 and the first electrode 160 and a contact area between the channel layer 130 and the second electrode 140 are maximized.

In an implementation, as shown in FIG. 20c, the channel layer 130 is stacked on the concave wall surface 1003s of the first channel hole 1003 shown in FIG. 19d. In this case, with reference to FIG. 17a, a boundary of an orthographic projection of the channel layer 130 on the substrate 1001 is located outside a boundary of an overlapping part (namely, the first overlapping part 140a1, the second overlapping part 140a2, the third overlapping part 140a3, or the fourth overlapping part 140a4) between an orthographic projection of the first electrode 160 on the substrate 1001 and an orthographic projection of the second electrode 140 on the substrate 1001. For the transistor formed in this way, a contact area between the channel layer 130 and the first electrode 160 and a contact area between the channel layer 130 and the second electrode 140 are further increased.

In an implementation, as shown in FIG. 20a, the channel layer 130 is stacked on the first surface 140a. In this case, the contact area between the channel layer 130 and the second electrode 140 is increased.

Still refer to FIG. 12.

S5: As shown in FIG. 21, stack a gate dielectric layer 120 on the channel layer 130.

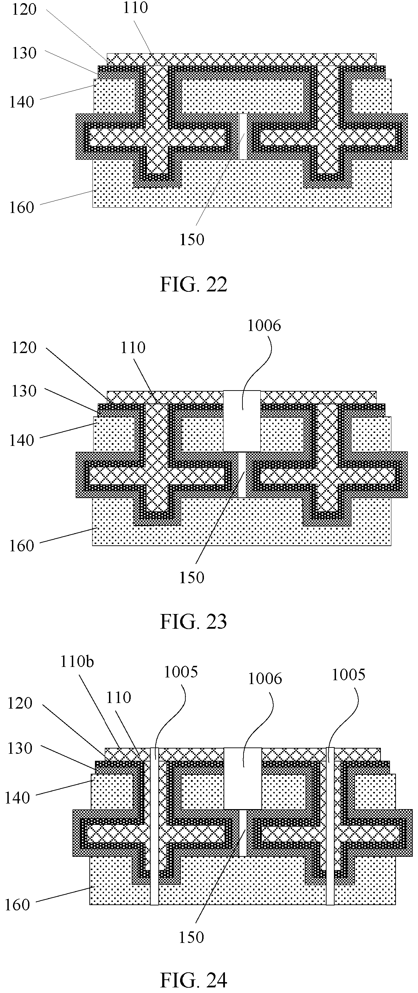

S6: As shown in FIG. 22, stack a gate 110 on the gate dielectric layer 120.

As shown in FIG. 22, in an implementation, after the channel layer 130 and the gate dielectric layer 120 are sequentially stacked in the first channel hole 1003, and when the gate 110 continues to be stacked, a remaining part of the first channel hole 1003 is filled, so that a structure is simple. This is easy to process, and facilitates array arrangement and production of the transistor.

In this way, steps S1 to S6 are performed, so that the transistor including the first electrode, the second electrode, the channel layer, the gate dielectric layer, and the gate is formed on the substrate.

When preparation and array arrangement of the transistor are performed, to implement isolation between devices, after steps S1 to S6 are performed, the preparation method further includes step S7.

S7: As shown in FIG. 23, cut off the transistor in the direction (the Z direction) perpendicular to the substrate, to form a plurality of transistors including the first electrode, the second electrode, the channel layer, the gate dielectric layer, and the gate.

For example, as shown in FIG. 23, a fourth groove 1006 is formed through photoetching or etching, to cut off the transistor. In addition, electrical isolation between two adjacent transistors may be implemented by filling the fourth groove 1006 with an insulating medium material.

In addition, to further reduce a volume of the transistor, after steps S1 to S6 are performed, the preparation method further includes step S8.

S8: As shown in FIG. 24, provide a second surface 110b that is of the gate 110 and that is away from the first electrode 160 with a gap 1005 that sequentially passes through the gate 110, the gate dielectric layer 120, the channel layer 130, and the first electrode 160, and fill the gap 1005 with an insulating medium material, so that the chip is separated into a plurality of parts.

The gap 1005 may be in a straight shape, to divide the transistor into two parts. The gap 1005 may alternatively be in a cross shape, to divide the transistor into four parts. A shape of the gap 1005 is not limited in this application.

According to the chip prepared by using the preparation method provided in this embodiment of this application, a side wall surface of the first channel hole 1003 is a concave wall surface 1003s, and the channel layer 130 is formed on the concave wall surface 1003s. In this way, the contact area between the channel layer 130 and the first electrode 160 and the contact area between the channel layer 130 and the second electrode 140 are increased, thereby improving a gate control capability, and increasing an on-state current of the chip.

To improve ohmic contact between the first electrode and the channel layer, and further improve an on-state current of the transistor, in some embodiments, after step S1 is performed and before step S2 is performed, the preparation method further includes step S14.

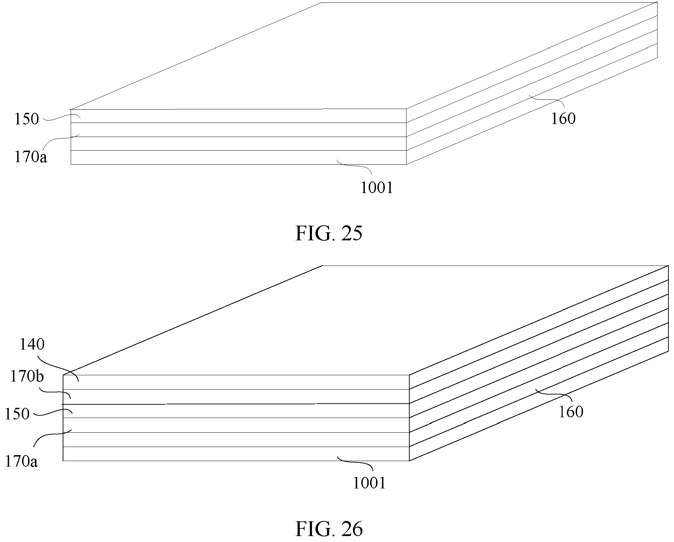

S14: As shown in FIG. 25, stack a first doped layer 170a on the first electrode 160.

As shown in FIG. 25, in an implementation, before step S2 is performed, the preparation method further includes: stacking a dielectric layer 150 on the first doped layer 170a.

To improve ohmic contact between the second electrode and the channel layer, and further improve an on-state current of the transistor, in some embodiments, after step S1 is performed and before step S2 is performed, the preparation method further includes step S15.

S15: As shown in FIG. 26, stack a second doped layer 170b on a side that is of the first electrode 160 and that is away from the substrate 1001.

Electrical isolation may be implemented between the second doped layer 170b and the first electrode 160 by disposing the dielectric layer.

As shown in FIG. 26, in an implementation, the second doped layer 170b is stacked on the dielectric layer 150, so that the stacked second doped layer 170b is electrically isolated from the first electrode 160.

In an implementation, the first doped layer 170a is stacked on the first electrode 160, the dielectric layer 150 is stacked on the first doped layer 170a, the second doped layer 170b is stacked on the dielectric layer 150, and the second electrode 140 is stacked on the second doped layer 170b, to form the transistor structure of the first electrode 160, the first doped layer 170a, the dielectric layer 150, the second doped layer 170b, and the second electrode 140, and improve ohmic contact between the first electrode 160, the second electrode 140, and the channel layer 130 (where for a process of forming the channel layer 130 on the dielectric layer 150, refer to the foregoing embodiments, and details are not described herein again).

In addition, to increase a probability of bonding carriers (electrons and holes) and further improve an on-state current of the transistor, P-type or N-type doping may be performed on at least a part of structures of the first doped layer 170a and the second doped layer 170b. For a doping manner, refer to the foregoing chip embodiments. Details are not described herein again.

The first doped layer 170a and/or the second doped layer 170b are/is added, to improve the ohmic contact between the first electrode 160, the second electrode 140, and the channel layer 130, and further improve the on-state current of the transistor.

In the descriptions of this specification, the described specific features, structures, materials, or characteristics may be combined in a proper manner in any one or more of embodiments or examples.

Finally, it should be noted that the foregoing embodiments are merely intended for describing the technical solutions of this application other than limiting this application. Although this application is described in detail with reference to the foregoing embodiments, persons of ordinary skill in the art should understand that they may still make modifications to the technical solutions described in the foregoing embodiments, without departing from the scope of the technical solutions of embodiments of this application.

## Claims

1. A chip, comprising:
a substrate (1001) and a transistor formed on the substrate, wherein
the transistor comprises: a first electrode (160), a second electrode (140), a channel layer (130), a gate (110), and a gate dielectric layer (120);
the first electrode (160) is stacked on the substrate, the second electrode (140) is stacked on a side that is of the first electrode and that is away from the substrate, the second electrode has a first surface away from the first electrode, and the first surface is provided with a first channel hole extending into the first electrode; **characterised in that**
a part that is of a side wall of the first channel hole and that is located between the first electrode and the second electrode is concave in a direction parallel to the substrate to form a concave cavity, so that a side wall surface of the first channel hole is a concave wall surface;
the channel layer covers the concave wall surface; and
the gate covers the channel layer, and the gate and the channel layer are isolated through the gate dielectric layer

2. The chip according to claim 1, wherein the first surface is covered with the channel layer, the channel layer on the first surface is covered with the gate, and the channel layer on the first surface and the gate are isolated through the gate dielectric layer

3. The chip according to claim 1 or 2, wherein the gate, the gate dielectric layer, and the channel layer fill the first channel hole.

4. The chip according to any one of claims 1 to 3, wherein the chip further comprises:
a dielectric layer, formed between the first electrode and the second electrode, wherein
the concave cavity is formed in the dielectric layer, and the concave cavity passes through the dielectric layer in a direction perpendicular to the substrate.

5. The chip according to any one of claims 1 to 4, wherein the chip further comprises:
a first doped layer, formed on a surface that is of the first electrode and that is close to the second electrode, and located between the first electrode and the channel layer

6. The chip according to claim 5, wherein a doping type of the first doped layer is different from that of the channel layer, one of the first doped layer and the channel layer is of P-type doping, and the other is of N-type doping.

7. The chip according to any one of claims 1 to 6, wherein the chip further comprises:
a second doped layer, formed on a surface that is of the second electrode and that is close to the first electrode, and located between the second electrode and the channel layer.

8. The chip according to claim 7, wherein a doping type of the second doped layer is different from that of the channel layer, one of the second doped layer and the channel layer is of P-type doping, and the other is of N-type doping.

9. The chip according to any one of claims 1 to 8, wherein a boundary of an orthographic projection, on the substrate, of a part that is of the channel layer and that is located between the first electrode and the second electrode is located within a boundary of an overlapping part between an orthographic projection of the first electrode on the substrate and an orthographic projection of the second electrode on the substrate.

10. The chip according to any one of claims 1 to 8, wherein a boundary of an orthographic projection, on the substrate, of a part that is of the channel layer and that is located between the first electrode and the second electrode is located outside a boundary of an overlapping part between an orthographic projection of the first electrode on the substrate and an orthographic projection of the second electrode on the substrate.

11. The chip according to any one of claims 1 to 10, wherein the gate has an upper surface and a lower surface that are located at two ends of the gate in the direction perpendicular to the substrate, the upper surface is a surface that is of the gate and that is away from the first electrode, the upper surface is provided with a gap that sequentially passes through the gate, the gate dielectric layer, the channel layer, and the first electrode, and the gap is filled with an insulating medium material.

12. The chip according to any one of claims 1 to 11, wherein the chip is a memory, the memory comprises a storage unit, and the storage unit comprises the transistor.

13. A chip preparation method, comprising:
stacking a first electrode (160) on a substrate (1001);
stacking a second electrode (140) on a side that is of the first electrode and that is away from the substrate; **characterised by**
providing a first surface that is of the second electrode and that is away from the first electrode with a first channel hole extending into the first electrode, wherein a part that is of a side wall of the first channel hole and that is located between the first electrode and the second electrode is concave in a direction parallel to the substrate to form a concave cavity, so that a side wall surface of the first channel hole is a concave wall surface;
stacking a channel layer (130) on the concave wall surface, so that the channel layer covers the concave wall surface;
stacking a gate dielectric layer (120) on the channel layer, so that the gate dielectric layer covers the channel layer; and
stacking a gate (110) on the gate dielectric layer (120), so that the gate covers the gate dielectric layer, to form, on the substrate, a transistor comprising the first (160), the second electrode (140), the channel layer (130), the gate dielectric layer (120), and the gate (110).

14. The chip preparation method according to claim 13, wherein when the channel layer is formed, the channel layer is enabled to cover the first surface;
when the gate dielectric layer is formed, the gate dielectric layer is enabled to cover the channel layer on the first surface; and
when the gate is formed, the gate is enabled to cover the gate dielectric layer on the first surface.

15. An electronic device, comprising:
a printed circuit board; and the chip according to any one of claims 1 to 12, wherein the chip is disposed on the printed circuit board and is electrically connected to the printed circuit board.

## Patentansprüche

1. Chip, der umfasst:
ein Substrat (1001) und ein auf dem Substrat gebildeter Transistor, wobei der Transistor umfasst: eine erste Elektrode (160), eine zweite Elektrode (140), eine Kanalschicht (130), ein Gate (110) und eine Gate-Dielektriumschicht (120);
die erste Elektrode (160) auf dem Substrat gestapelt ist, die zweite Elektrode (140) auf einer Seite der ersten Elektrode gestapelt ist, und die von dem Substrat entfernt ist, die zweite Elektrode eine erste Oberfläche aufweist, die von der ersten Elektrode entfernt ist, und die erste Oberfläche mit einem ersten Kanalloch bereitgestellt ist, das sich in die erste Elektrode erstreckt; **dadurch gekennzeichnet, dass**
ein Teil einer Seitenwand des ersten Kanallochs, und der sich zwischen der ersten Elektrode und der zweiten Elektrode befindet, in einer Richtung parallel zu dem Substrat konkav ist, um einen konkaven Hohlraum zu bilden, sodass eine Seitenwandoberfläche des ersten Kanallochs eine konkave Wandoberfläche ist;
die Kanalschicht die konkave Wandoberfläche bedeckt; und
das Gate die Kanalschicht bedeckt, und das Gate und die Kanalschicht durch die Gate-Dielektriumschicht isoliert sind.

2. Chip nach Anspruch 1, wobei die erste Oberfläche mit der Kanalschicht bedeckt ist, die Kanalschicht auf der ersten Oberfläche mit dem Gate bedeckt ist und die Kanalschicht auf der ersten Oberfläche und das Gate durch die Gate-Dielektriumschicht isoliert sind.

3. Chip nach Anspruch 1 oder 2, wobei das Gate, die Gate-Dielektriumschicht und die Kanalschicht das erste Kanalloch füllen.

4. Chip nach einem der Ansprüche 1 bis 3, wobei der Chip ferner umfasst:
eine Dielektriumschicht, die zwischen der ersten Elektrode und der zweiten Elektrode gebildet ist, wobei
der konkave Hohlraum in der Dielektriumschicht gebildet ist, und der konkave Hohlraum in einer Richtung senkrecht zu dem Substrat durch die Dielektriumschicht verläuft.

5. Chip nach einem der Ansprüche 1 bis 4, wobei der Chip ferner umfasst:
eine erste dotierte Schicht, die auf einer Oberfläche der ersten Elektrode gebildet und nahe der zweiten Elektrode angeordnet ist und sich zwischen der ersten Elektrode und der Kanalschicht befindet.

6. Chip nach Anspruch 5, wobei sich ein Dotierungstyp der ersten dotierten Schicht von dem der Kanalschicht unterscheidet, eine von der ersten dotierten Schicht und der Kanalschicht von einer P-Typ-Dotierung ist und die andere von einer N-Typ-Dotierung ist.

7. Chip nach einem der Ansprüche 1 bis 6, wobei der Chip ferner umfasst:
eine zweite dotierte Schicht, die auf einer Oberfläche der zweiten Elektrode gebildet und die nahe der ersten Elektrode ist und sich zwischen der zweiten Elektrode und der Kanalschicht befindet.

8. Chip nach Anspruch 7, wobei sich ein Dotierungstyp der zweiten dotierten Schicht von dem der Kanalschicht unterscheidet, eine von der zweiten dotierten Schicht und der Kanalschicht von einer P-Typ-Dotierung ist und die andere von einer N-Typ-Dotierung ist.

9. Chip nach einem der Ansprüche 1 bis 8, wobei sich eine Grenze einer orthografischen Projektion auf das Substrat eines Teils der Kanalschicht, und der sich zwischen der ersten Elektrode und der zweiten Elektrode befindet, innerhalb einer Grenze eines überlappenden Teils zwischen einer orthografischen Projektion der ersten Elektrode auf das Substrat und einer orthografischen Projektion der zweiten Elektrode auf das Substrat befindet.

10. Chip nach einem der Ansprüche 1 bis 8, wobei sich eine Grenze einer orthografischen Projektion auf das Substrat eines Teils der Kanalschicht, und der sich zwischen der ersten Elektrode und der zweiten Elektrode befindet, außerhalb einer Grenze eines überlappenden Teils zwischen einer orthografischen Projektion der ersten Elektrode auf das Substrat und einer orthografischen Projektion der zweiten Elektrode auf das Substrat befindet.

11. Chip nach einem der Ansprüche 1 bis 10, wobei das Gate eine obere Oberfläche und eine untere Oberfläche aufweist, die sich in der Richtung senkrecht zu dem Substrat an zwei Enden des Gates befinden, wobei die obere Oberfläche eine Oberfläche des Gates ist, und die von der ersten Elektrode entfernt ist, wobei die obere Oberfläche mit einem Spalt bereitgestellt wird, der nacheinander durch das Gate, die Gate-Dielektriumschicht, die Kanalschicht und die erste Elektrode verläuft, und wobei der Spalt mit einem isolierenden Mediummaterial gefüllt ist.

12. Chip nach einem der Ansprüche 1 bis 11, wobei der Chip ein Speicher ist, der Speicher eine Speicherungseinheit umfasst und die Speicherungseinheit den Transistor umfasst.

13. Chipherstellungsverfahren, das umfasst:
Stapeln einer ersten Elektrode (160) auf einem Substrat (1001);
Stapeln einer zweiten Elektrode (140) auf einer Seite der ersten Elektrode, und die von dem Substrat entfernt ist; **gekennzeichnet durch**
Bereitstellen einer ersten Oberfläche der zweiten Elektrode, und die von der ersten Elektrode entfernt ist, mit einem ersten Kanalloch, das sich in die erste Elektrode erstreckt, wobei ein Teil einer Seitenwand des ersten Kanallochs, und der sich zwischen der ersten Elektrode und der zweiten Elektrode befindet, in einer Richtung parallel zu dem Substrat konkav ist, um einen konkaven Hohlraum zu bilden, sodass eine Seitenwandoberfläche des ersten Kanallochs eine konkave Wandoberfläche ist;
Stapeln einer Kanalschicht (130) auf der konkaven Wandoberfläche, sodass die Kanalschicht die konkave Wandoberfläche bedeckt;
Stapeln einer Gate-Dielektriumschicht (120) auf der Kanalschicht, sodass die Gate-Dielektriumschicht die Kanalschicht bedeckt; und
Stapeln eines Gates (110) auf der Gate-Dielektriumschicht (120), sodass das Gate die Gate-Dielektriumschicht bedeckt, um auf dem Substrat einen Transistor zu bilden, der die erste (160), die zweite Elektrode (140), die Kanalschicht (130), die Gate-Dielektriumschicht (120) und das Gate (110) umfasst.

14. Chipherstellungsverfahren nach Anspruch 13, wobei, wenn die Kanalschicht gebildet wird, die Kanalschicht in der Lage ist, die erste Oberfläche zu bedecken;
wenn die Gate-Dielektriumschicht gebildet wird, die Gate-Dielektriumschicht in der Lage ist, die Kanalschicht auf der ersten Oberfläche zu bedecken; und
wenn das Gate gebildet wird, das Gate in der Lage ist, die Gate-Dielektriumschicht auf der ersten Oberfläche zu bedecken.

15. Elektronische Vorrichtung, die umfasst:
eine Leiterplatte; und den Chip nach einem der Ansprüche 1 bis 12, wobei der Chip auf der Leiterplatte eingerichtet ist und mit der Leiterplatte elektrisch verbunden ist.

## Revendications

1. Puce comprenant :
un substrat (1001) et un transistor formé sur le substrat, dans laquelle le transistor comprend : une première électrode (160), une seconde électrode (140), une couche de canal (130), une grille (110) et une couche diélectrique de grille (120) ;
la première électrode (160) est empilée sur le substrat, la seconde électrode (140) est empilée sur un côté qui appartient à la première électrode et qui est éloigné du substrat, la seconde électrode a une première surface éloignée de la première électrode, et la première surface est pourvue d'un premier trou de canal s'étendant dans la première électrode ; **caractérisée en ce que**
une partie qui appartient à une paroi latérale du premier trou de canal et qui est située entre la première électrode et la seconde électrode est concave dans une direction parallèle au substrat pour former une cavité concave, de sorte qu'une surface de paroi latérale du premier trou de canal est une surface de paroi concave ;
la couche de canal recouvre la surface de paroi concave ; et
la grille recouvre la couche de canal, et la grille et la couche de canal sont isolées par l'intermédiaire de la couche diélectrique de grille.

2. Puce selon la revendication 1, dans laquelle la première surface est recouverte par la couche de canal, la couche de canal sur la première surface est recouverte de la grille, et la couche de canal sur la première surface et la grille sont isolées par l'intermédiaire de la couche diélectrique de grille.

3. Puce selon la revendication 1 ou 2, dans laquelle la grille, la couche diélectrique de grille et la couche de canal remplissent le premier trou de canal.

4. Puce selon l'une quelconque des revendications 1 à 3, dans laquelle la puce comprend en outre :
une couche diélectrique, formée entre la première électrode et la seconde électrode, dans laquelle
la cavité concave est formée dans la couche diélectrique, et la cavité concave traverse la couche diélectrique dans une direction perpendiculaire au substrat.

5. Puce selon l'une quelconque des revendications 1 à 4, dans laquelle la puce comprend en outre :
une première couche dopée, formée sur une surface qui appartient à la première électrode et qui est proche de la seconde électrode, et située entre la première électrode et la couche de canal.

6. Puce selon la revendication 5, dans laquelle un type de dopage de la première couche dopée est différent de celui de la couche de canal, l'une parmi la première couche dopée et la couche de canal est à dopage de type P, et l'autre est à dopage de type N.

7. Puce selon l'une quelconque des revendications 1 à 6, dans laquelle la puce comprend en outre :
une seconde couche dopée, formée sur une surface qui appartient à la seconde électrode et qui est proche de la première électrode, et située entre la seconde électrode et la couche de canal.

8. Puce selon la revendication 7, dans laquelle un type de dopage de la seconde couche dopée est différent de celui de la couche de canal, l'une parmi la seconde couche dopée et la couche de canal est à dopage de type P, et l'autre est à dopage de type N.

9. Puce selon l'une quelconque des revendications 1 à 8, dans laquelle une limite d'une projection orthographique, sur le substrat, d'une partie qui appartient à la couche de canal et qui est située entre la première électrode et la seconde électrode est située à l'intérieur d'une limite d'une partie de chevauchement entre une projection orthographique de la première électrode sur le substrat et une projection orthographique de la seconde électrode sur le substrat.

10. Puce selon l'une quelconque des revendications 1 à 8, dans laquelle une limite d'une projection orthographique, sur le substrat, d'une partie qui appartient à la couche de canal et qui est située entre la première électrode et la seconde électrode est située à l'extérieur d'une limite d'une partie de chevauchement entre une projection orthographique de la première électrode sur le substrat et une projection orthographique de la seconde électrode sur le substrat.

11. Puce selon l'une quelconque des revendications 1 à 10, dans laquelle la grille a une surface supérieure et une surface inférieure qui sont situées à deux extrémités de la grille dans la direction perpendiculaire au substrat, la surface supérieure est une surface qui appartient à la grille et qui est éloignée de la première électrode, la surface supérieure est pourvue d'un espace qui traverse séquentiellement la grille, la couche diélectrique de grille, la couche de canal et la première électrode, et l'espace est rempli d'un matériau de milieu isolant.

12. Puce selon l'une quelconque des revendications 1 à 11, dans laquelle la puce est une mémoire, la mémoire comprend une unité de stockage, et l'unité de stockage comprend le transistor.

13. Procédé de préparation de puce, comprenant :
l'empilement d'une première électrode (160) sur un substrat (1001) ;
l'empilement d'une seconde électrode (140) sur un côté qui appartient à la première électrode et qui est éloigné du substrat ; **caractérisé par**
le fait de pourvoir une première surface qui appartient à la seconde électrode et qui est éloignée de la première électrode d'un premier trou de canal s'étendant dans la première électrode, dans lequel une partie qui appartient à une paroi latérale du premier trou de canal et qui est située entre la première électrode et la seconde électrode est concave dans une direction parallèle au substrat pour former un cavité concave, de sorte qu'une surface de paroi latérale du premier trou de canal est une surface de paroi concave ;
l'empilement d'une couche de canal (130) sur la surface de paroi concave, de sorte que la couche de canal recouvre la surface de paroi concave ;
l'empilement d'une couche diélectrique de grille (120) sur la couche de canal, de sorte que la couche diélectrique de grille recouvre la couche de canal ; et
l'empilement d'une grille (110) sur la couche diélectrique de grille (120), de sorte que la grille couvre la couche diélectrique de grille, pour former, sur le substrat, un transistor comprenant la première électrode (160), la seconde électrode (140), la couche de canal (130), la couche diélectrique de grille (120), et la grille (110).

14. Procédé de préparation de puce selon la revendication 13, dans lequel, lorsque la couche de canal est formée, la couche de canal est en mesure de recouvrir la première surface ;
lorsque la couche diélectrique de grille est formée, la couche diélectrique de grille est en mesure de couvrir la couche de canal sur la première surface ; et
lorsque la grille est formée, la grille est en mesure de recouvrir la couche diélectrique de grille sur la première surface.

15. Dispositif électronique, comprenant :
une carte de circuit imprimé ; et la puce selon l'une quelconque des revendications 1 à 12, dans lequel la puce est disposée sur la carte de circuit imprimé et est connectée électriquement à la carte de circuit imprimé.
